(19) Europäisches Patentamt / European Patent Office / Office européen des brevets

(11) EP 2 116 574 B1

(12) **EUROPEAN PATENT SPECIFICATION**

(45) Date of publication and mention of the grant of the patent: **10.07.2013 Bulletin 2013/28**

(21) Application number: **08704463.2**

(22) Date of filing: **05.02.2008**

(51) Int Cl.: ***C09K 11/06*** (2006.01) ***C08K 5/00*** (2006.01) ***C08K 5/3462*** (2006.01) ***C08L 65/00*** (2006.01) ***H01L 51/50*** (2006.01)

(86) International application number: **PCT/JP2008/051836**

(87) International publication number: **WO 2008/096735 (14.08.2008 Gazette 2008/33)**

(54) **COMPOSITION CONTAINING PYRIMIDINE COMPOUND AND LUMINESCENT ELEMENT EMPLOYING THE COMPOSITION**

ZUSAMMENSETZUNG, DIE EINE PYRIMIDINVERBINDUNG ENTHÄLT, UND LUMINESZENZELEMENT UNTER VERWENDUNG DER ZUSAMMENSETZUNG

COMPOSITION CONTENANT UN COMPOSÉ PYRIMIDINE ET ÉLÉMENT LUMINESCENT UTILISANT LA COMPOSITION

(84) Designated Contracting States: **AT BE BG CH CY CZ DE DK EE ES FI FR GB GR HR HU IE IS IT LI LT LU LV MC MT NL NO PL PT RO SE SI SK TR**

(30) Priority: **06.02.2007 JP 2007026558**

(43) Date of publication of application: **11.11.2009 Bulletin 2009/46**

(73) Proprietor: **Sumitomo Chemical Company, Limited**
**Tokyo 104-8260 (JP)**

(72) Inventors:
- **AKINO, Nobuhiko**
  **Tsukuba-shi**
  **Ibaraki (JP)**
- **TANAKA, Kenta**
  **Tsukuba-shi**
  **Ibaraki 305-0045 (JP)**
- **HIGASHIMURA, Hideyuki**
  **Tsukuba-shi**
  **Ibaraki 305-0045 (JP)**

(74) Representative: **Duckworth, Timothy John**
**J A Kemp**
**14 South Square**
**Gray's Inn**
**London WC1R 5JJ (GB)**

(56) References cited:
**WO-A1-2005/063919**
**JP-A- 07 196 780**
**JP-A- 2002 105 444**
**JP-A- 2004 031 004**
**JP-A- 2005 116 238**
**JP-A- 2006 156 445**
**JP-A- 2006 504 862**
**US-A1- 2006 093 852**
**US-A1- 2006 180 806**

Remarks:
The file contains technical information submitted after the application was filed and not included in this specification

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 2 116 574 B1

## Description

### TECHNICAL FIELD

The present invention relates to a composition containing pyrimidine compound and a light-emitting device using the composition.

### BACKGROUND ART

A light-emitting device comprising a compound that exhibits light emission from a triplet excited state (hereinafter, also referred to as a "phosphorescence-emitting compound") used as a light-emitting material for a light-emitting layer therein has been known to have high luminous efficiency. When the phosphorescence-emitting compound is used in a light-emitting layer, a composition comprising the compound added to a matrix is usually used as a light-emitting material. A compound such as polyvinylcarbazole is used as the matrix, because a thin film can be formed by application (PATENT DOCUMENT 1).
However, such a compound has the problem that the lowest unoccupied molecular orbital (hereinafter, also referred to as "LUMO") is high, thus resulting in difficult electron injection. On the other hand, when a conjugated polymer such as polyfluorene is used as the matrix, low drive voltage can be obtained relatively easily because of its low LUMO. However, such a conjugated polymer has a small lowest triplet excitation energy and is therefore considered to be unsuitable particularly for use as a matrix for light emission with a wavelength shorter than green light emission (PATENT DOCUMENT 2). For example, a light-emitting material comprising a conjugated polymer polyfluorene and a triplet light-emitting compound (NON-PATENT DOCUMENT 1) has low luminous efficiency.
PATENT DOCUMENT 1: JP-A-2002-50483
PATENT DOCUMENT 2: JP-A-2002-241455
NON-PATENT DOCUMENT 1: APPLIED PHYSICS LETTERS, 80, 13, 2308 (2002)
US-A-2006/180806 discloses organic electroluminescence devices.
US-A-2006/093852 discloses phosphorescent or luminescent conjugated polymers.
JP-A-2002-105444 discloses a method for synthesizing a heteroaromatic ring-containing vinyl monomer derivable to a specific heteroaromatic ring-containing polymer, and an organic light-emitting element material composed of the polymer.
JP-A-2005-116238 discloses an organic EL element.

### DISCLOSURE OF THE INVENTION

### PROBLEMS TO BE SOLVED BY THE INVENTION

Thus, an object of the present invention is to provide a light-emitting material that is excellent in luminous efficiency when used in the light-emitting devices or the like.

### MEANS FOR SOLVING THE PROBLEMS

The present inventor has conducted diligent studies and consequently completed the present invention by finding that a composition comprising: a compound having a pyrimidine ring structure; and a phosphorescence-emitting compound solves the problems described above.
Specifically, a first aspect of the present invention provides a composition comprising: a compound having a pyrimidine ring structure; and a phosphorescence-emitting compound according to claim 1.
A second aspect of the present invention provides a light-emitting thin film, an organic semiconductor thin film and a light-emitting device using the composition or the polymer.
A third aspect of the present invention provides a planar light source, a segment display device, a dot matrix display device and illumination comprising the light-emitting device as well as a liquid-crystal display device comprising the light-emitting device as a backlight.

### ADVANTAGES OF THE INVENTION

A composition and a polymer of the present invention (hereinafter, referred to as a "composition, etc., of the present invention") have high luminous efficiency. Thus, the composition, etc., of the present invention gives light-emitting

devices excellent in luminous efficiency, when used in the preparation of light-emitting devices or the like. Moreover, the composition, etc., of the present invention usually has relatively excellent light-emitting properties in green to blue light emission. This is because the polymer of the present invention as a compound (compound having a pyrimidine ring) contained in the composition of the present invention has a large lowest triplet excitation energy. Moreover, it also permits easy electron injection because of relatively low LUMO.

BEST MODE FOR CARRYING OUT THE INVENTION

Hereinafter, the present invention will be described in detail.

<Composition>

A composition of the present invention comprises: a compound having a pyrimidine ring structure; and a phosphorescence-emitting compound, wherein the compound having a pyrimidine ring structure has a pyrimidine ring structure represented by the general formula (1), (2), (3), (1a), (2a) or (3a) and a partial structure adjacent to the pyrimidine ring structure, the partial structure having at least two $\pi$-conjugated electrons, wherein the pyrimidine ring structure and the partial structure form a dihedral angle of 30° or larger therebetween calculated from the optimized structure of the ground state by a Hartree-Fock method, 6-31g* being used as a basis function, or when 6-31g* is unavailable, LANL2DZ being used instead:

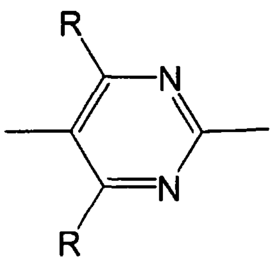
(1)

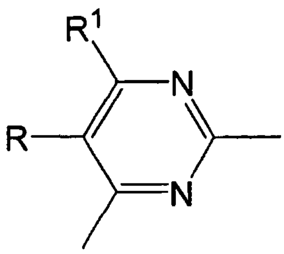
(2)

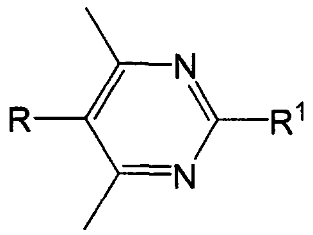
(3)

wherein R and $R^1$ each independently represent a hydrogen atom or a monovalent substituent, and when a plurality of R and $R^1$ are present, they may be the same or different;

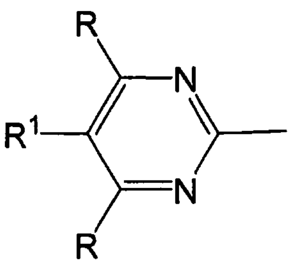
(1a)

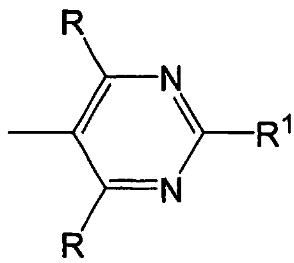
(2a)

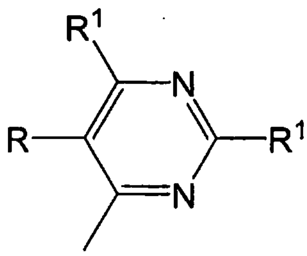
(3a)

wherein R and $R^1$ are as defined above, and when a plurality of R and $R^1$ are present, they may be the same or different; the partial structure being selected from divalent and trivalent aromatic groups, and structures represented by the following formula (4):

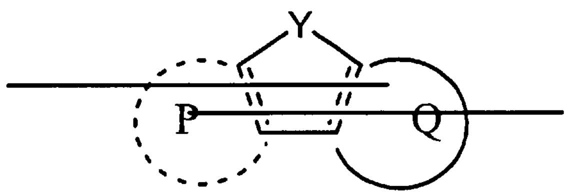
(4)

wherein

- the P ring may be absent;
- the P ring, if present, and the Q ring each independently represent an aromatic ring;
- if the P ring is present, each of the two bonds (——) are present on the P ring or the Q ring; and
- if the P ring is absent, each of the two bonds (——) are present on the Y-containing five-membered or six-membered ring or the Q ring;

and wherein the P ring, the Q ring or the Y-containing five-membered or six-membered ring may have a substituent selected from the group consisting of an alkyl group, an alkoxy group, an alkylthio group, an aryl group, an aryloxy group, an arylthio group, an arylalkyl group, an arylalkoxy group, an arylalkylthio group, an arylalkenyl group, an arylalkynyl group, an amino group, a substituted amino group, a silyl group, a substituted silyl group, a halogen atom, an acyl group, an acyloxy group, an imine residue, an amide group, an acid imide group, a monovalent heterocyclic group, a carboxyl group, a substituted carboxyl group and a cyano group; Y represents -O-, -S-, -Se-, -B($R^0$)-, -Si($R^2$) ($R^3$)-, - P($R^4$)-, -P ($R^5$)(=O)-, -C($R^6$)($R^7$)-, -N($R^8$)-, - C ($R^9$) ($R^{10}$)-C($R^{11}$) ($R^{12}$)_, -O-C($R^{13}$) ($R^{14}$)-, -S-C ($R^{15}$) ($R^{16}$)-, -N-C($R^{17}$) ($R^{18}$)-, -Si ($R^{19}$) ($R^{20}$)-C ($R^{21}$) ($R^{22}$) -, -Si ($R^{23}$) ($R^{24}$) -Si ($R^{25}$) ($R^{26}$) -,-C($R^{27}$)=C($R^{28}$)-, -N=C($R^{29}$)-, or -Si($R^{30}$)=C($R^{31}$)-; $R^0$ and $R^2$ to $R^{31}$ each independently represent a hydrogen atom, an alkyl group, an alkoxy group, an alkylthio group, an aryl group, an aryloxy group, an arylthio group, an arylalkyl group, an arylalkoxy group, an arylalkylthio group, an arylalkenyl group, an arylalkynyl group, an amino group, a substituted amino group, a silyl group, a substituted silyl group, a silyloxy group, a substituted silyloxy group, a monovalent heterocyclic group or a halogen atom; or the partial structure is an aromatic amine having a structure represented by the following formula:

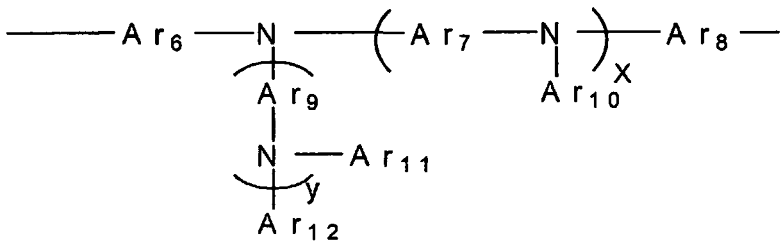

wherein $Ar_6$, $Ar_7$, $Ar_8$ and $Ar_9$ each independently represent an arylene group or a divalent heterocyclic group; $Ar_{10}$, $Ar_{11}$ and $Ar_{12}$ each independently represent an aryl group or a monovalent heterocyclic group; $Ar_6$ to $Ar_{12}$ may have a substituent; and x and y each independently represent 0 or 1, wherein $0 \leq x+y \leq 1$.

When the compound having a pyrimidine ring structure is a polymer, the compound is more preferably a polymer having the pyrimidine ring structure in the main chain and/or the side chain of the polymer, particularly preferably a polymer whose repeating unit is a structure represented by the general formula (1), (2), (3), (1a), (2a) or (3a) or a polymer containing, in addition to the structure represented by the general formula (1), (2), (3), (1a), (2a) or (3a), any structure selected from an aromatic ring, a heteroatom-containing five or more membered heterocyclic ring, aromatic amine and a structure represented by the general formula (4).

In the formulas (1) to (3) and (1a) to (3a), R and $R^1$ each independently represent a hydrogen atom or a monovalent substituent. Preferably, at least one of a plurality of R and a plurality of $R^1$ is a monovalent substituent. More preferably, all of a plurality of R and a plurality of $R^1$ are a monovalent substituent. A plurality of R or $R^1$ may be the same or different.

Examples of the monovalent substituent include a halogen atom, an alkyl group, an alkoxy group, an alkylthio group, an aryl group which may have a substituent, an aryloxy group, an arylthio group, an arylalkyl group, an arylalkyloxy group, an arylalkylthio group, an acyl group, an acyloxy group, an amide group, an acid imide group, an imine residue, a substituted amino group, a substituted silyl group, a substituted silyloxy group, a substituted silylthio group, a substituted silylamino group, a monovalent heterocyclic group which may have a substituent, a heteroaryl group which may have a substituent, a heteroaryloxy group, a heteroarylthio group, an arylalkenyl group, an arylethynyl group, a substituted carboxyl group and a cyano group. Preferably, the monovalent group is an alkyl group, an alkoxy group, an aryl group which may have a substituent or a heteroaryl group which may have a substituent. In this context, the N-valent heterocyclic group (N is 1 or 2) refers to a group derived from a heterocyclic compound by removal of N hydrogen atom(s). This holds true for the present specification. In this context, the monovalent heterocyclic group is preferably a monovalent aromatic heterocyclic group.

It is preferred that at least one of the R and the $R^1$ should be an alkyl group, an alkoxy group, an aryl group which may have a substituent or a heteroaryl group which may have a substituent. It is more preferred that at least one of the R and the $R^1$ should be an alkyl group having 3 to 10 carbon atoms or an alkoxy group having 3 to 10 carbon atoms.

At least one of the R is a monovalent substituent having a total of preferably three or more atoms, more preferably five or more atoms, particularly preferably seven or more atoms, exclusive of hydrogen atoms. When two R are present, preferably at least one of the two R, more preferably both of the two R are the monovalent substituent. A plurality of R or $R^1$ may be the same or different.

Examples of the compound having a pyrimidine ring structure include a compound represented by the following general formula (A-1) or (A-2) and a compound having a residue thereof:

$$(\text{pyrimidine})\!-\!(Y^1)_n\text{-}Ar_1 \qquad \text{(A-1)}$$

$$(\text{Pyrimidine})\!-\!(Y^1)_n\!-\!(\text{pyrimidine}) \qquad \text{(A-2)}$$

wherein pyrimidine represents a pyrimidine ring structure represented by the general formula (1a), (2a) or (3a); when a plurality of pyrimidine are present, they may be the same or different; $Y^1$ represents - $C(R^a)(R^b)$-, -C (=O) -, -N($R^c$)-, -O-, -Si($R^d$)($R^e$)-, -P($R^f$)-, -S- or -S(=O)$_2$-; n is an integer of 0 to 5; $Ar_1$ represents a monovalent aryl group which may have a substituent or a monovalent heterocyclic group which may have a substituent; when a plurality of $Y^1$ are present, they may be the same or different; and $R^a$ to $R^f$ each independently represent a hydrogen atom or a monovalent substituent. In this context, the pyrimidine ring structure contained in one molecule is at least one.

Examples of the aryl group represented by $Ar_1$ include phenyl, $C_1$ to $C_{12}$ alkoxyphenyl (the term "$C_1$ to $C_{12}$ alkoxy" means that the alkoxy moiety has 1 to 12 carbon atoms; the same holds true for description below), $C_1$ to $C_{12}$ alkylphenyl (the term "$C_1$ to $C_{12}$ alkyl" means that the alkyl moiety has 1 to 12 carbon atoms; the same holds true for description below), 1-naphthyl, 2-naphthyl and pentafluorophenyl groups. Phenyl, $C_1$ to $C_{12}$ alkoxyphenyl and $C_1$ to $C_{12}$ alkylphenyl groups are preferable.

The monovalent heterocyclic group represented by $Ar_1$ means an atomic group derived from a heterocyclic compound by removal of one hydrogen atom. In this context, the heterocyclic compound refers to, of organic compounds having a cyclic structure, those endocyclically containing not only a carbon atom but also heteroatoms such as oxygen, sulfur, nitrogen and phosphorus atoms as elements constituting the ring.

Examples of the monovalent substituent represented by $R^a$ to $R^f$ include an alkyl group, an alkoxy group, an alkylthio group, an aryl group, an aryloxy group, an arylthio group, an arylalkyl group, an arylalkoxy group, an arylalkylthio group, an arylalkenyl group, an arylalkynyl group, an amino group, a substituted amino group, a silyl group, a substituted silyl group, a silyloxy group, a substituted silyloxy group, a monovalent heterocyclic group and a halogen atom.

In this context, it is preferred from the viewpoint of luminous efficiency that the compound having a pyrimidine ring structure should have a pyrimidine ring structure other than a residue of a compound represented by the following general formula (A-3)

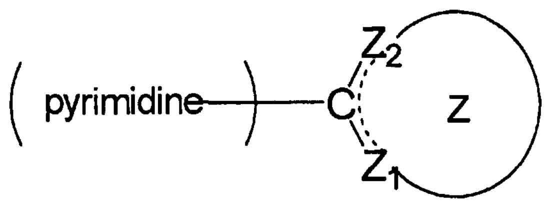

(A-3)

wherein pyrimidine is as defined above; the Z ring is a cyclic structure containing a carbon atom, $Z_1$ and $Z_2$; and $Z_1$ and $Z_2$ each independently represent -C(H)= or - N=.

In the formula (A-3), examples of the cyclic structure include an aromatic ring which may have a substituent and a non-aromatic ring which may have a substituent and specifically include a benzene ring, a heterocyclic ring, an alicyclic hydrocarbon ring, condensed rings of these rings in any combination, and these rings whose hydrogen atoms are partially substituted.

The residue of the compound represented by the formulas (A-1) to (A-3) means a group derived from the compound by removal of some or all of hydrogen atoms.

The compound having a pyrimidine ring structure has an additional partial structure which may be selected from divalent and trivalent aromatic groups. In this context, the aromatic group refers to a group derived from an organic compound that exhibits aromaticity. Examples of such an aromatic group include groups derived from aromatic rings such as benzene, naphthalene, anthracene, pyridine, quinoline and isoquinoline by substitution of n' (n' is 2 or 3) hydrogen atoms by a bond.

Alternatively, the partial structure is a structure represented by the following formula (4):

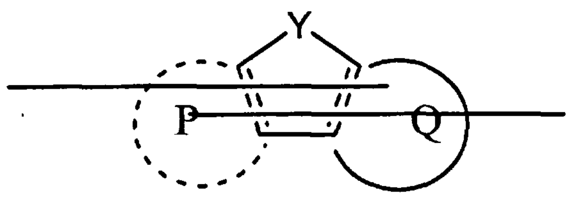

(4)

wherein

- the P ring may be absent;
- the P ring, if present, and the Q ring each independently represent an aromatic ring
- if the P ring is present, each of the two bonds (——) are present on the P ring or the Q ring; and
- if the P ring is absent, each of the two bonds (——) are present on the Y-containing five-membered or six-membered ring or the Q ring;

and wherein the P ring, the Q ring or the Y-containing five-membered or six-membered ring may have a substituent selected from the group consisting of an alkyl group, an alkoxy group, an alkylthio group, an aryl group, an aryloxy group, an arylthio group, an arylalkyl group, an arylalkoxy group, an arylalkylthio group, an arylalkenyl group, an arylalkynyl group, an amino group, a substituted amino group, a silyl group, a substituted silyl group, a halogen atom, an acyl group, an acyloxy group, an imine residue, an amide group, an acid imide group, a monovalent heterocyclic group, a carboxyl group, a substituted carboxyl group and a cyano group. Y represents -O-, -S-, -Se-, -B($R^0$)-, - Si ($R^2$) ($R^3$) -, -P ($R^4$) -, -P ($R^5$) (=O) -, -C($R^6$)($R^7$)-, -N($R^8$)-, - C($R^9$)($R^{10}$)-C($R^{11}$)($R^{12}$)-, -O-C($R^{13}$)($R^{14}$)-, -S-C ($R^{15}$)($R^{16}$)-, - N-C($R^{17}$)($R^{18}$)-, -Si ($R^{19}$)($R^{20}$)-C($R^{21}$)($R^{22}$)-, -Si($R^{23}$)($R^{24}$)-Si($R^{25}$)($R^{26}$)-, -C($R^{27}$)=C($R^{28}$)-, -N=C($R^{29}$)-, or - Si($R^{30}$)=C($R^{31}$)-, In this context, $R^0$ and $R^2$ to $R^{31}$ each independently represent a hydrogen atom, an alkyl group, an alkoxy group, an alkylthio group, an aryl group, an aryloxy group, an arylthio group, an arylalkyl group, an arylalkoxy group, an arylalkylthio group, an arylalkenyl group, an arylalkynyl group, an amino group, a substituted amino group, a silyl group, a substituted silyl group, a silyloxy group, a substituted silyloxy group, a monovalent heterocyclic group or a halogen atom. Among them, an alkyl group, an alkoxy group, an alkylthio group, an aryl group, an aryloxy group, an arylthio group, an arylalkyl group, an arylalkoxy group, and a monovalent heterocyclic group are preferable. An alkyl group, an alkoxy group, an aryl group and a monovalent heterocyclic group are more preferable, and an alkyl group and an aryl group are particularly preferable.

Examples of the structure represented by the formula (4) include: a structure represented by the following formula (4-1), (4-2) or (4-3):

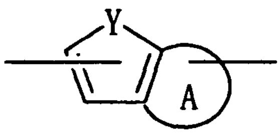

(4-1)

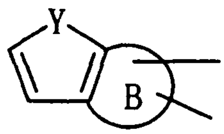

(4-2)

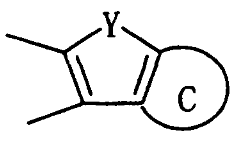

(4-3)

wherein the A ring, the B ring and the C ring each independently represent an aromatic ring; the formulas (4-1), (4-2) and (4-3) may respectively have a substituent selected from the group consisting of an alkyl group, an alkoxy group, an alkylthio group, an aryl group, an aryloxy group, an arylthio group, an arylalkyl group, an arylalkoxy group, an arylalkylthio group, an arylalkenyl group, an arylalkynyl group, an amino group, a substituted amino group, a silyl group, a substituted silyl group, a halogen atom, an acyl group, an acyloxy group, an imine residue, an amide group, an acid imide group, a monovalent heterocyclic group, a carboxyl group, a substituted carboxyl group and a cyano group; and Y is as defined above; and a structure represented by the following formula (4-4) or (4-5):

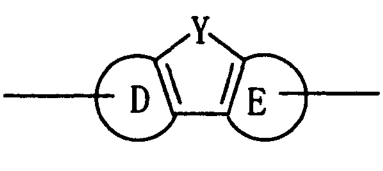

(4-4)

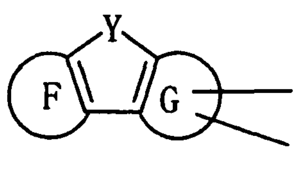

(4-5)

wherein the D ring, the E ring, the F ring and the G ring each independently represent an aromatic ring which may have a substituent selected from the group consisting of an alkyl group, an alkoxy group, an alkylthio group, an aryl group, an aryloxy group, an arylthio group, an arylalkyl group, an arylalkoxy group, an arylalkylthio group, an arylalkenyl group, an arylalkynyl group, an amino group, a substituted amino group, a silyl group, a substituted silyl group, a halogen atom, an acyl group, an acyloxy group, an imine residue, an amide group, an acid imide group, a monovalent heterocyclic group, a carboxyl group, a substituted carboxyl group and a cyano group; and Y is as defined above.
In the formulas (4-4) and (4-5), Y is preferably a carbon atom, a nitrogen atom, an oxygen atom or a sulfur atom, because high luminous efficiency can be obtained.

In the formulas (4-1), (4-2), (4-3), (4-4) and (4-5), examples of unsubstituted aromatic rings represented by the A ring, the B ring, the C ring, the D ring, the E ring, the F ring and the G ring include: aromatic hydrocarbon rings such as benzene, naphthalene, anthracene, tetracene, pentacene, pyrene and phenanthrene rings; and heterocyclic aromatic rings such as pyridine, bipyridine, phenanthroline, quinoline, isoquinoline, thiophene, furan and pyrrole rings. These aromatic rings may have the substituent.

Alternatively, the partial structure is an aromatic amine having a structure represented by the following formula:

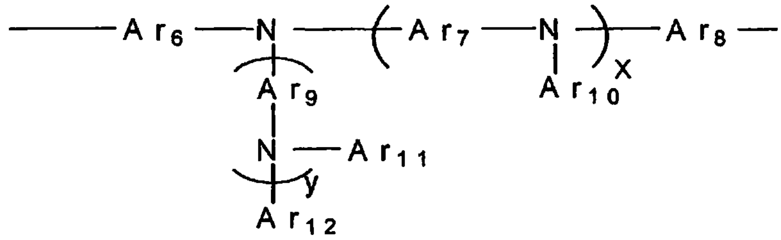

wherein $Ar_6$, $Ar_7$, $Ar_8$ and $Ar_9$ each independently represent an arylene group or a divalent heterocyclic group; $Ar_{10}$, $Ar_{11}$ and $Ar_{12}$ each independently represent an aryl group or a monovalent heterocyclic group; $Ar_6$ to $Ar_{12}$ may have a substituent; and x and y each independently represent 0 or 1, wherein $0 \leq x+y \leq 1$.

One preferable example of the additional partial structure which may be contained in the compound having a pyrimidine ring structure includes a structure represented by the following general formula (B):

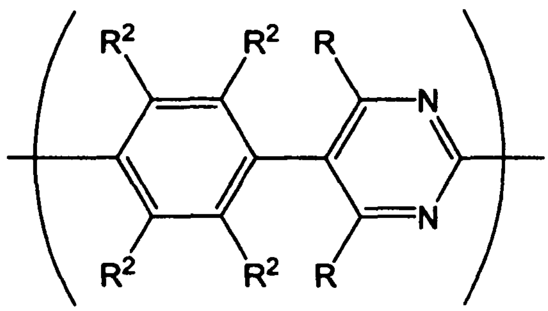

(B)

wherein R is as defined above; $R^2$ represents a hydrogen atom or a monovalent substituent; and when a plurality of R or $R^2$ are present, they may be the same or different.

In the general formula (B), the monovalent substituent represented by $R^2$ is the same as above.

The compound containing the structure represented by the general formula (B) can be produced by any method and, preferably, is produced by a method comprising performing a cross-coupling reaction between a structure represented by the following general formula (C) and a structure represented by the following general formula (D):

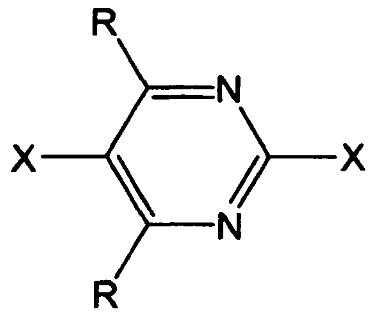

(C)

wherein R is as defined above; X represents a halogen atom or a group represented by $-SO_3Q$ (wherein Q represents a monovalent hydrocarbon group which may be substituted); and two X may be the same or different, and

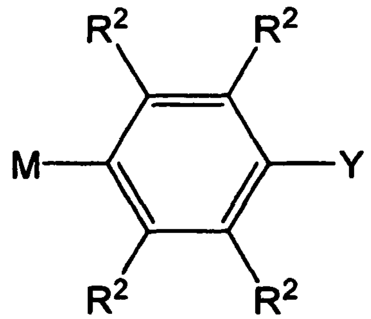

(D)

wherein $R^2$ is as defined above; M represents $-B(OQ^1)_2$-$Si(Q^2)_3$, $-Sn(Q^3)_3$ or $-Z^1(Z^2)_m$ (wherein $Q^1$ represents a hydrogen atom or a monovalent hydrocarbon group; two $Q^1$ may be the same or different and may form a ring; $Q^2$ represents a monovalent hydrocarbon group; three $Q^2$ may be the same or different; $Q^3$ represents a monovalent hydrocarbon group; three $Q^3$ may be the same or different; $Z^1$ represents a metal atom or a metal ion; and $Z^2$ represents a counter anion; and m is an integer of 0 or larger); and Y represents a hydrogen atom or the same as those defined in the X.

When the compound having a pyrimidine ring structure is a polymer, the compound has a weight-average molecular weight of preferably $3\times10^2$ or larger, more preferably $3\times10^2$ to $1\times10^7$, even more preferably $1\times10^3$ to $1\times10^7$, particularly preferably $1\times10^4$ to $1\times10^7$, based on polystyrene standards from the viewpoint of film formability.

The compound having a pyrimidine ring structure can be used in a wide emission wavelength region. To that end, preferably, the compound has the lowest triplet excitation energy (hereinafter, also referred to as a "$T_1$ energy") of preferably 2.7 eV or larger, more preferably 2.9 eV or larger, even more preferably 3.0 eV or larger, still preferably 3.1 eV or larger, particularly preferably 3.2 eV or larger. Moreover, the upper limit thereof is usually 5.0 eV.

The highest occupied molecular orbital (HOMO) and lowest unoccupied molecular orbital (LUMO) energy levels of the compound having a pyrimidine ring structure are not particularly limited. The compound having a pyrimidine ring structure has an absolute value of a LUMO energy level of preferably 1.5 eV or larger, more preferably 1.7 eV or larger, even more preferably 1.9 eV or larger, still preferably 2.0 eV or larger, particularly preferably 2.2 eV or larger. Moreover, the upper limit thereof is usually 4.0 eV.

In the present specification, the values of the $T_1$ energy and the LUMO energy level are values calculated by a computational chemical approach. In the present specification, the quantum chemical calculation program Gaussian 03 is used as the computational chemical approach. The structure of the ground state was optimized by an HF (Hartree-Fock) method, and the values of the $T_1$ energy and the LUMO energy level were calculated in the optimized structure using a time-dependent density functional method at a B3P86 level. In this procedure, 6-31g* was used as a basis function. When 6-31g* is unavailable as a basis function, LANL2DZ is used instead.

When the compound having a pyrimidine ring structure comprises one type of repeating unit which is defined as A, the compound having a pyrimidine ring structure is represented by the following formula:

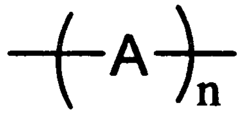

wherein n represents the degree of polymerization.
In this context, values of a $T_1$ energy and a LUMO energy level are calculated for structures wherein n=1, 2 and 3, and values at n=∞ in linear approximation with the calculated values of the $T_1$ energy and the LUMO energy level as functions of (1/n) are defined as the values of the $T_1$ energy and the LUMO energy level of the polymer.

When the compound having a pyrimidine ring structure comprises a plurality of repeating units, a $T_1$ energy at n=∞ (wherein n represents the degree of polymerization of the repeating unit) is calculated in all the cases in the same way as above, and the lowest $T_1$ energy among them is defined as the $T_1$ energy of the compound. A value of the LUMO energy level at n=∞ of a repeating unit that gives the lowest value of the $T_1$ energy is defined as the value of the LUMO energy level of the polymer. In the present invention, an absolute value of the "value of the LUMO energy level" is important.

The pyrimidine ring structure represented by the general formula (1), (2), (3), (1a), (2a) or (3a) and the partial structure adjacent to the pyrimidine ring structure, having at least two π-conjugated electrons. form therebetween a dihedral angle of 30° or larger, preferably 40° or larger, still preferably 50° or larger, particularly preferably 60° or larger. Furthermore, in the compound having a pyrimidine ring structure, all aromatic rings and heteroaromatic rings (which include the pyrimidine ring structure) form therebetween a dihedral angle of preferably 30° or larger, more preferably 40° or larger, even more preferably 50° or larger, particularly preferably 60° or larger. Moreover, for obtaining such a dihedral angle, it is preferred that the compound should be free from the pyrimidine ring structure represented by the general formula (A-3).

In this context, the dihedral angle in the present invention means an angle calculated from the optimized structure of the ground state. The dihedral angle is defined, for example, by, in the pyrimidine ring structure represented by the general formula (1), (2), (3), (1a), (2a) or (3a), a carbon atom ($a_1$) at the position of the bond and a carbon atom or nitrogen atom ($a_2$) adjacent to $a_1$, and by, in the structure bonded to the pyrimidine ring structure, an atom ($a_3$) at the position of the bond and an atom ($a_4$) adjacent to $a_3$. In this context, when a plurality of atoms ($a_2$) or ($a_4$) can be selected, a dihedral angle is calculated in all the cases, and the lowest value among all absolute values is defined as the dihedral angle. The atom ($a_3$) is an atom with a π-conjugated electron, and the atom ($a_4$) may be an atom with or without a π-conjugated electron and is preferably an atom with a π-conjugated electron, more preferably a carbon atom, a nitrogen atom, a silicon atom or a phosphorus atom. In the present specification, it is calculated from the optimized structure of the ground state of a structure wherein n=3 (n is the degree of polymerization) determined by the computational chemical approach (i.e., a structure with the lowest heat of formation). When the compound having a pyrimidine ring structure has a plurality of the pyrimidine ring structures, it also has a plurality of the dihedral angles. In this case, it is preferred that all the dihedral angles in the polymer should satisfy the conditions described above.

Examples of the compound having the pyrimidine ring structure include the compounds represented by the formulas (5-1) to (5-26) shown below. In the formulas (5-1) to (5-26) shown below, $R^*$ represents a hydrogen atom or a monovalent substituent. The monovalent substituent represented by $R^*$ is exemplified by a halogen atom, an alkyl group, an alkoxy group, an alkylthio group, an aryl group which may have a substituent, an aryloxy group, an arylthio group, an arylalkyl group, an arylalkyloxy group, an arylalkylthio group, an acyl group, an acyloxy group, an amide group, an acid imide group, an imine residue, a substituted amino group, a substituted silyl group, a substituted silyloxy group, a substituted silylthio group, a substituted silylamino group, a monovalent heterocyclic group which may have a substituent, a heteroaryl group which may have a substituent, a heteroaryloxy group, a heteroarylthio group, an arylalkenyl group, an arylethynyl group, a substituted carboxyl group and a cyano group. A plurality of $R^*$ may be the same or different. $R^*$ is more preferably an alkyl group, an alkoxy group, an aryl group which may have a substituent, or a heteroaryl group which may have a substituent. A plurality of $R^*$ may be the same or different.

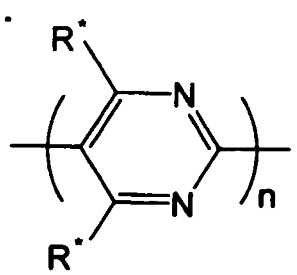
(5-1)

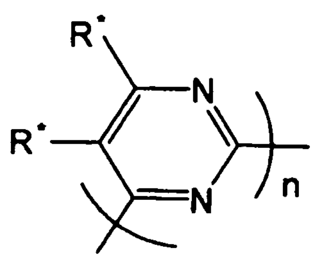
(5-2)

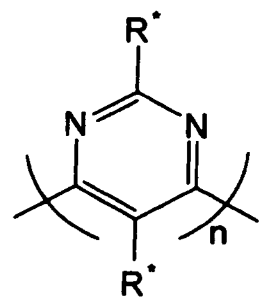
(5-3)

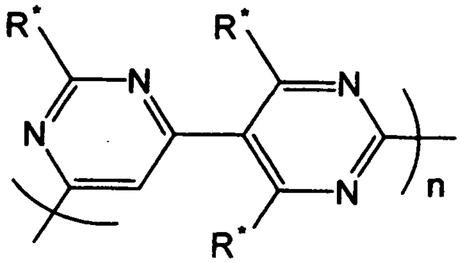

(5-4)

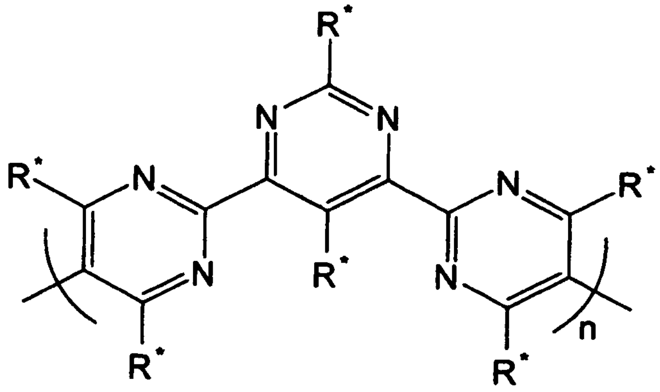

(5-5)

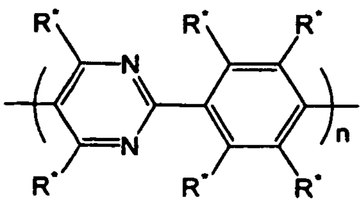

(5-6)

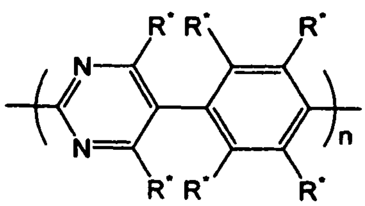

(5-7)

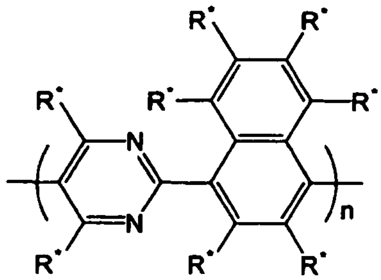

(5-8)

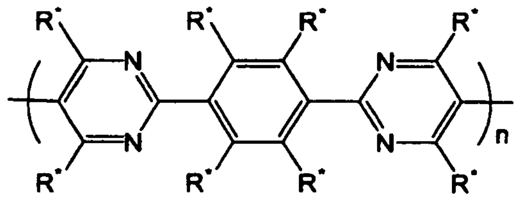

(5-9)

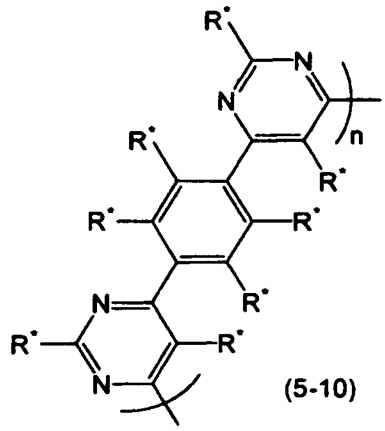

(5-10)

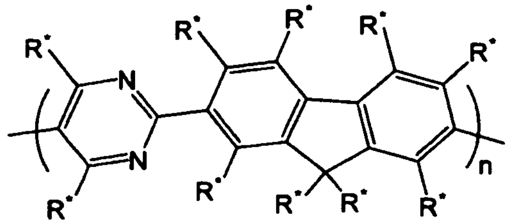

(5-11)

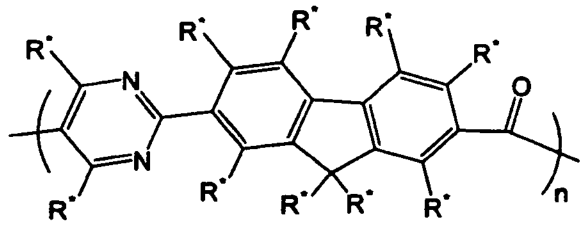

(5-13)

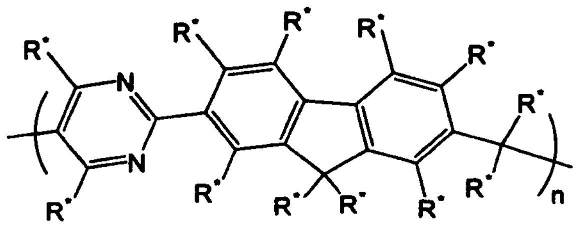

(5-12)

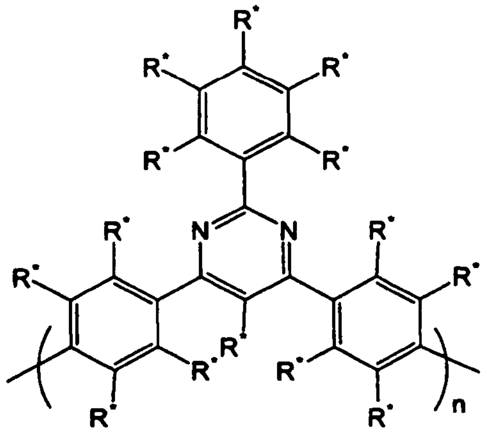

(5-16)

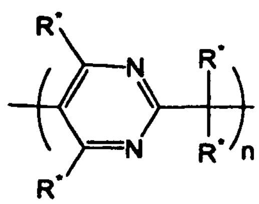

(5-14)

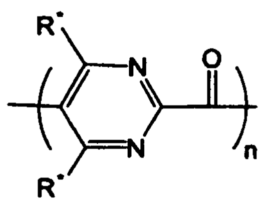

(5-15)

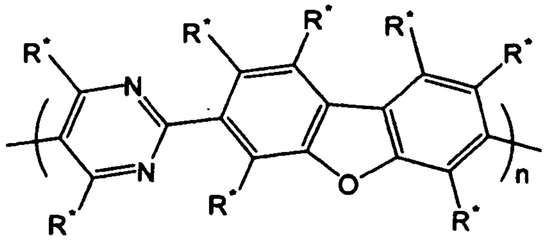

(5-17)

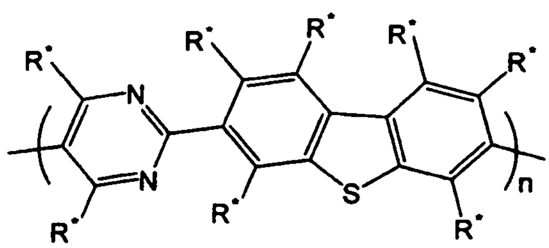

(5-18)

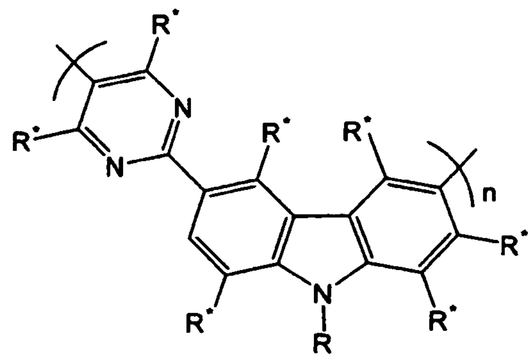

(5-19)

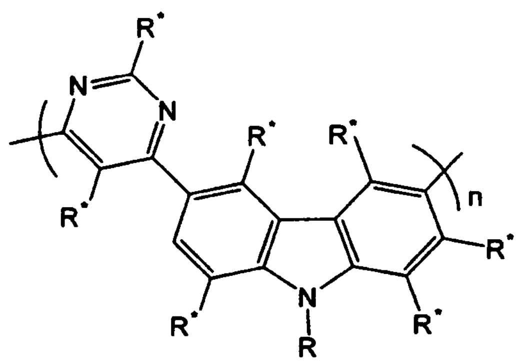

(5-20)

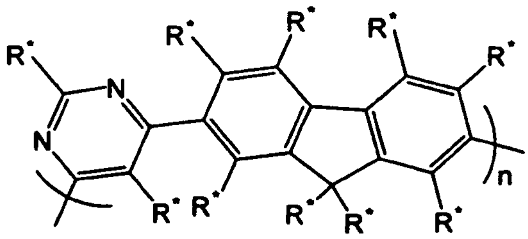

(5-21)

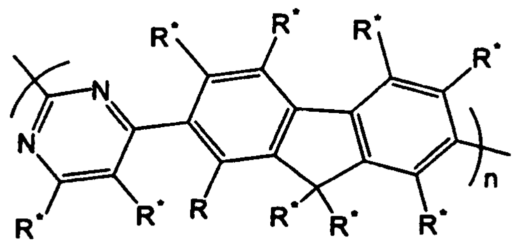

(5-22)

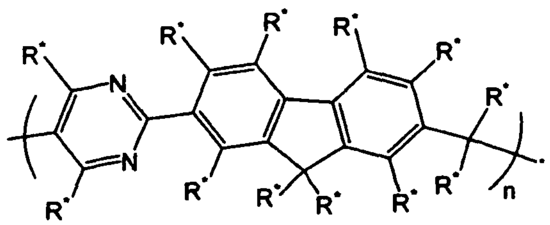

(5-23)

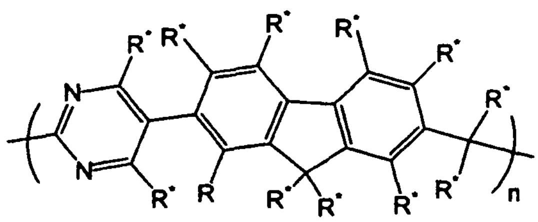

(5-24)

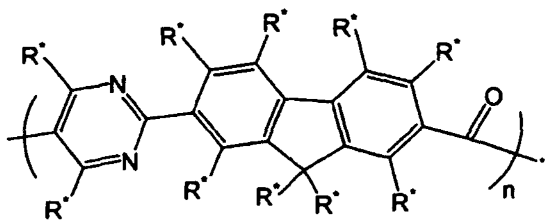

(5-25)

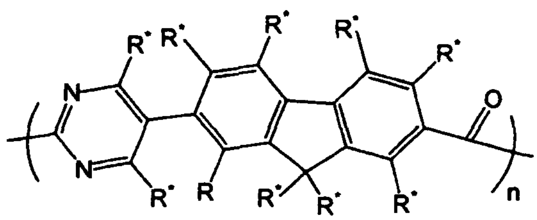

(5-26)

wherein n represents the degree of polymerization.

Moreover, preferably, examples of the compound having a pyrimidine ring structure include the followings:

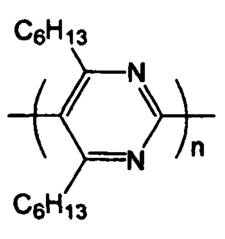
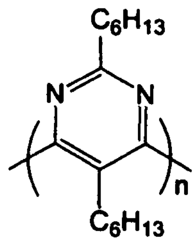
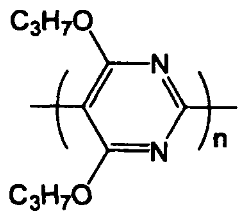

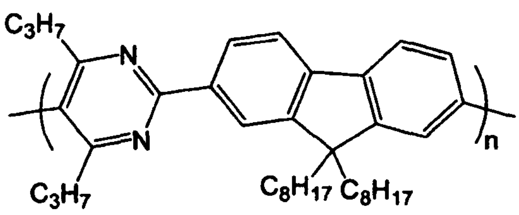
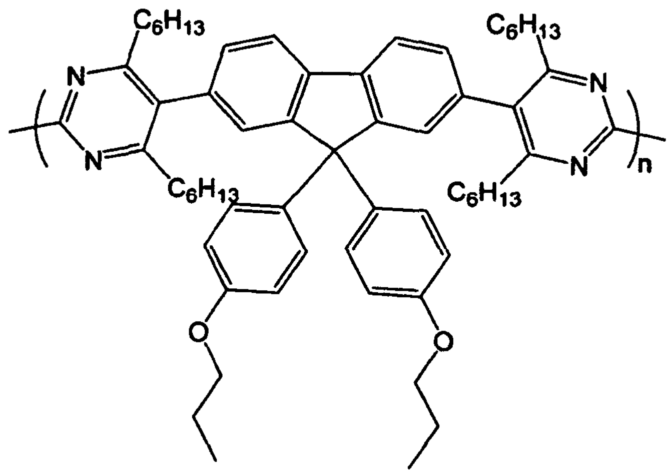

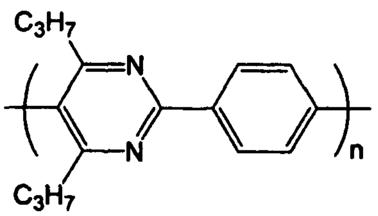
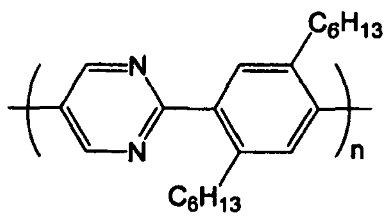

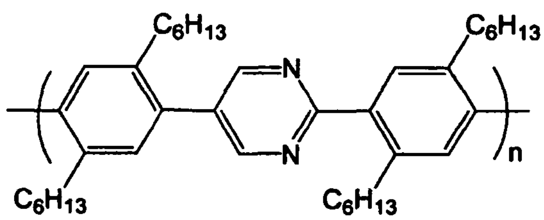
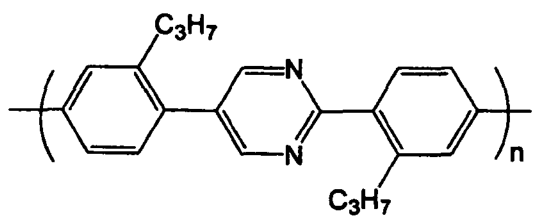

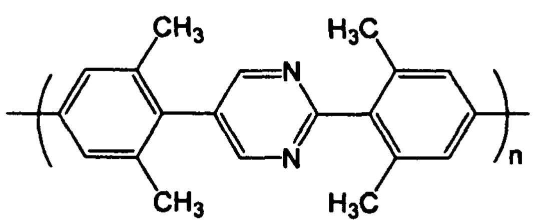
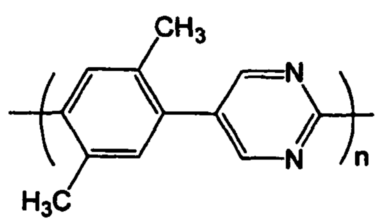

wherein n represents the degree of polymerization.

Moreover, examples of the compound having a pyrimidine ring structure can also include the followings:

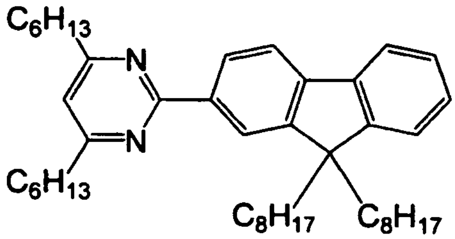

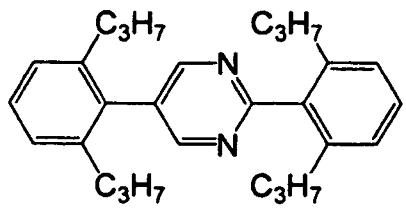

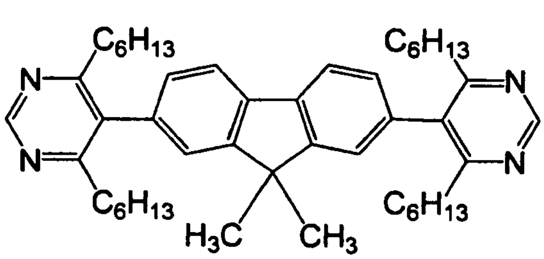

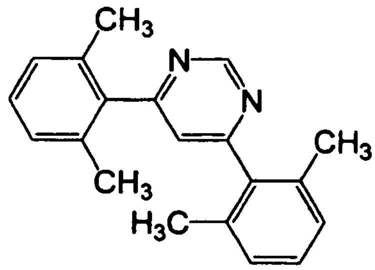

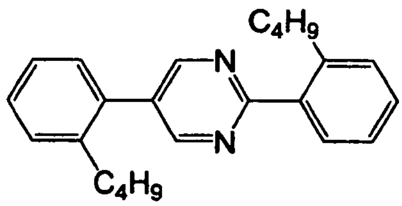

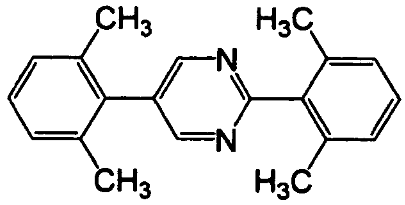

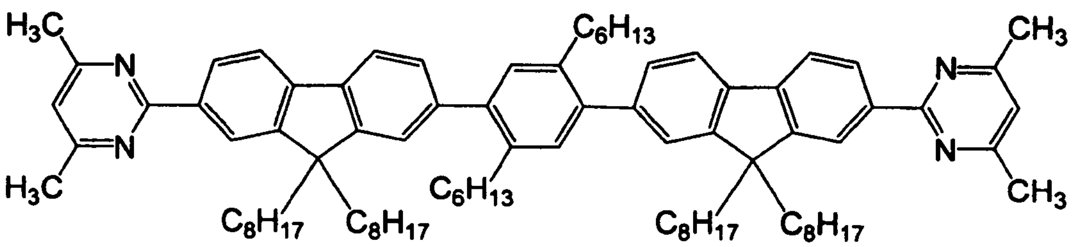

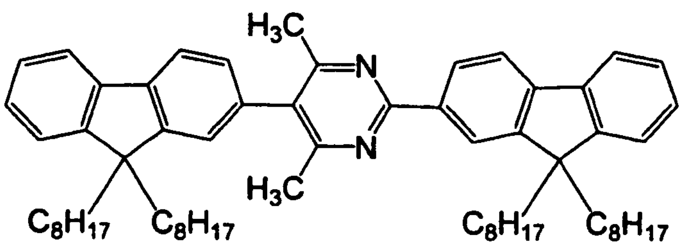

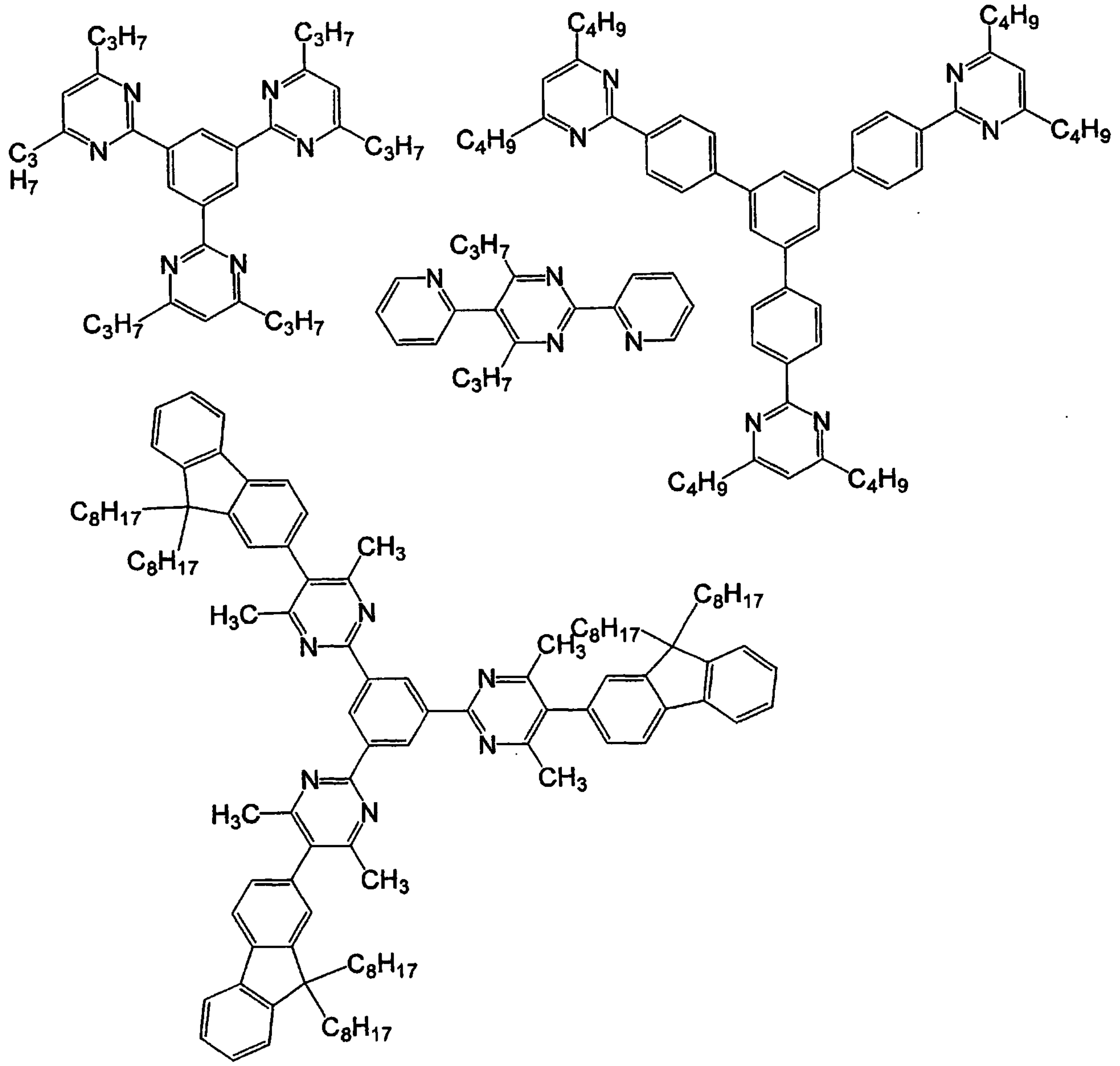

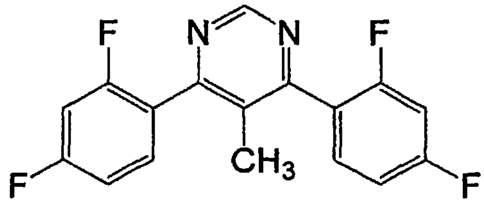

Compounds known in the art such as triplet light-emitting complexes can be used as the phosphorescence-emitting compound. Examples thereof include those previously used as low-molecular EL-emitting materials. They are disclosed in, for example, Nature, (1998), 395, 151; Appl. Phys, Lett. (1999), 75 (1), 4; Proc. SPIE-Int. Soc. Opt. Eng. (2001), 4105 (Organic Light-Emitting Materials and Devices IV), 119; J. Am. Chem. Soc., (2001), 123, 4304; Appl. Phys. Lett., (1997), 71 (18), 2596; Syn. Met., (1998), 94 (1), 103; Syn. Met., (1999), 99 (2), 1361; Adv. Mater., (1999), 11 (10), 852; Inorg. Chem., (2003), 42, 8609; Inorg. Chem., (2004), 43, 6513; Journal of the SID 11/1, 161 (2003); WO2002/066552; WO2004/020504; WO2004/020448, etc. It is particularly preferred from the viewpoint of obtaining high luminous efficiency that in the highest occupied molecular orbital (HOMO) of a metal complex, the sum of the square of orbital coefficients of outermost d orbitals of the central metal should occupy 1/3 or larger of the sum of the square of all the atomic orbital coefficients. Examples thereof include ortho-metalated complexes having a transition metal belonging to the 6th period as a central metal.

The central metal in the triplet light-emitting complexes is usually an atom with an atomic number of 50 or higher and is a metal that is capable of causing spin-orbit interaction in the complex and causing intersystem crossing between singlet and triplet states. The central metal is preferably a gold, platinum, iridium, osmium, rhenium, tungsten, europium, terbium, thulium, dysprosium, samarium, praseodymium, gadolinium or ytterbium atom, more preferably a gold, platinum, iridium, osmium, rhenium or tungsten atom, even more preferably a gold, platinum, iridium, osmium or rhenium atom, most preferably a gold, platinum, iridium or rhenium atom, particularly preferably a platinum or iridium atom.

Examples of a ligand in the triplet light-emitting complex include 8-quinolinol and derivatives thereof, benzoquinolinol and derivatives thereof and 2-phenyl-pyridine and derivatives thereof.

The phosphorescence-emitting compound is preferably a compound having a substituent such as an alkyl group, an alkoxy group, an aryl group which may have a substituent or a heteroaryl group which may have a substituent from the viewpoint of solubility. Furthermore, the substituent has a total of preferably three or more atoms, more preferably five or more atoms, even more preferably seven or more atoms, particularly preferably ten or more atoms, exclusive of hydrogen atoms. Moreover, it is preferred that at least one substituent should be present in each ligand. The types of the substituents may be the same or different in each ligand.

Examples of the specific structures of the phosphorescence-emitting compound include the followings:

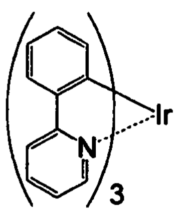
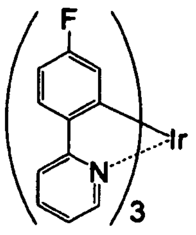
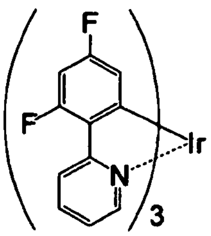
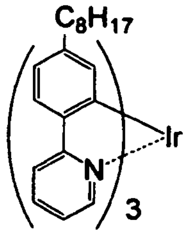
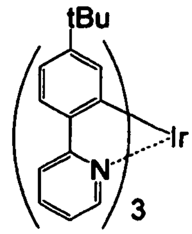

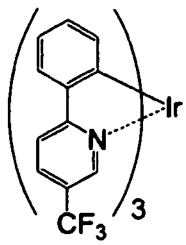
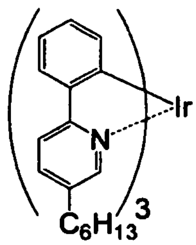
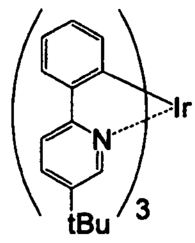
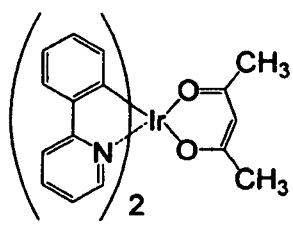

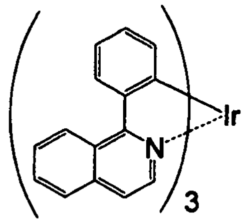
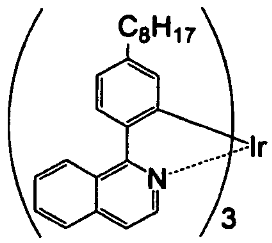
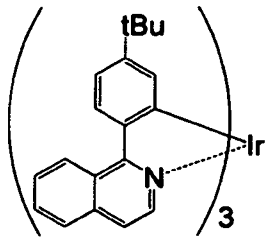
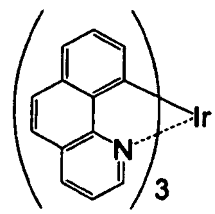

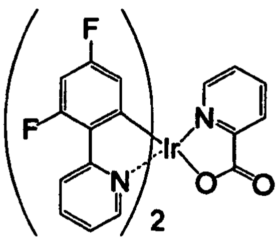
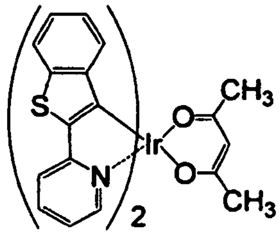
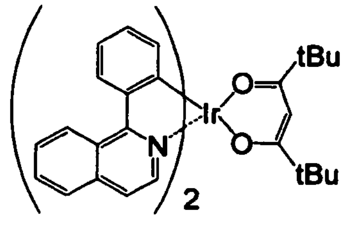

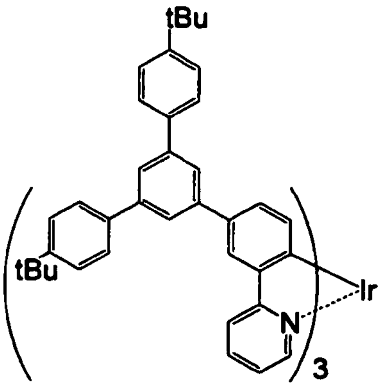

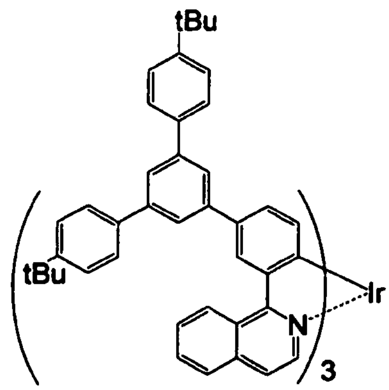

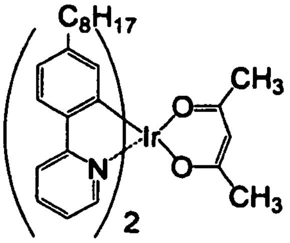

The amount of the phosphorescence-emitting compound in the composition of the present invention differs depending on the type of an organic compound combined therewith and a property to be optimized and therefore, is not particularly limited. The amount is usually 0.01 to 80 parts by weight, preferably 0.1 to 30 parts by weight, more preferably 0.1 to 15 parts by weight, particularly preferably 0.1 to 10 parts by weight, with respect to 100 parts by weight of the compound having a pyrimidine ring structure. In this context, in the composition of the present invention, the compound having a pyrimidine ring structure and the phosphorescence-emitting compound are respectively used alone or in combination of two or more thereof.

The composition of the present invention may comprise an optional component other than the compound having a pyrimidine ring structure and the phosphorescence-emitting compound without impairing the object of the present invention. Examples of this optional component include a hole transport material, an electron transport material and an antioxidant.

Examples of the hole transport material include aromatic amine, carbazole derivatives and polyparaphenylene derivatives known in the art as hole transport materials for organic EL devices.

Examples of the electron transport material include oxadiazole derivatives, anthraquinodimethane and derivatives thereof, benzoquinone and derivatives thereof, naphthoquinone and derivatives thereof, anthraquinone and derivatives thereof, tetracyanoanthraquinodimethane and derivatives thereof, fluorenone derivatives, diphenyldicyanoethylene and derivatives thereof, diphenoquinone derivatives metal complexes of 8-hydroxyquinoline and derivatives thereof known in the art as electron transport materials for organic EL devices.

In the composition of the present invention, it is preferred from the viewpoint of high luminous efficiency that the lowest triplet excitation energy (ETP) of the compound having a pyrimidine ring structure should satisfy, with a lowest triplet excitation energy (ETT) of the phosphorescence-emitting compound, the following formula:

$$ETT > ETP - 0.5\ (eV)$$, more preferably
$$ETT > ETP - 0.3\ (eV)$$, even more preferably
$$ETT > ETP - 0.2\ (eV).$$

Furthermore, it is preferred that ETP should be equal to or larger than ETT.

A light-emitting thin film of the present invention is obtained by forming a thin film comprising the composition, etc., of the present invention. Methods known in the art can be selected appropriately and used as the method for forming a thin film. Examples of the method include solution application, deposition and transfer. In the solution application, spin coating, casting, micro-gravure coating, gravure coating, bar coating, roll coating, wire bar coating, dip coating, spray coating, screen printing, flexographic printing, offset printing, inkjet methods, etc. may be used.

A solvent that can dissolve or uniformly disperse the composition therein is preferable. The solvent is exemplified by chlorine solvents (chloroform, methylene chloride, 1,2-dichloroethane, 1,1,2-trichloroethane, chlorobenzene, o-dichlorobenzene, etc.), ether solvents (tetrahydrofuran, dioxane, etc.), aromatic hydrocarbon solvents (toluene, xylene, etc.), aliphatic hydrocarbon solvents (cyclohexane, methylcyclohexane, n-pentane, n-hexane, n-heptane, n-octane, n-nonane, n-decane, etc.), ketone solvents (acetone, methyl ethyl ketone, cyclohexanone, etc.), ester solvents (ethyl acetate, butyl acetate, ethyl cellosolve acetate, etc.), polyhydric alcohols and derivatives thereof (ethylene glycol, ethylene glycol monobutyl ether, ethylene glycol monoethyl ether, ethylene glycol monomethyl ether, dimethoxyethane, propylene glycol, diethoxymethane, triethylene glycol monoethyl ether, glycerin, 1,2-hexanediol, etc.), alcoholic solvents (methanol, ethanol, propanol, isopropanol, cyclohexanol, etc.), sulfoxide solvents (dimethyl sulfoxide, etc.) and amide solvents (N-methyl-2-pyrrolidone, N,N-dimethylformamide, etc.). The solvent can be selected from among them and used. Moreover, these organic solvents may be used alone or in combination of two or more thereof.

When an inkjet method is used, methods known in the art for selecting a solvent in the solution or additives

can be used for improving discharge from a head, nonuniformity, and so on. In this case, it is preferred that the solution should have a viscosity of 1 to 100 mPa·s at 25°C. Moreover, excessive vaporization tends to make repetitive discharge from a head difficult. From these points of view, examples of preferable solvents used include single or mixed solvents containing anisole, bicyclohexyl, xylene, tetralin and dodecylbenzene. In general, a solution for inkjet suitable for the composition used can be obtained by a method comprising mixing a plurality of solvents, a method comprising adjusting a concentration in the solution of the composition, and so on.

<Polymer>

A polymer of the present invention has a residue of a phosphorescence-emitting compound and a pyrimidine ring structure. The phosphorescence-emitting compound and the pyrimidine ring structure are the same as those described and exemplified in the paragraph of the composition. Specific examples of the polymer of the present invention include (1) a polymer having the structure of the phosphorescence-emitting compound in the main chain, (2) a polymer having the structure of the phosphorescence-emitting compound in the end, and (3) a polymer having the structure of the phosphorescence-emitting compound in the side chain.

<Light-emitting device>

Next, a light-emitting device of the present invention will be described.
The light-emitting device of the present invention is obtained using the composition, etc., of the present invention. The light-emitting device usually comprises the composition, etc., of the present invention at least at a certain site between electrodes comprising an anode and a cathode and, preferably, comprises them in the form of the light-emitting thin film as a light-emitting layer. Moreover, the light-emitting device may comprise one or more of layers known in the art which have other functions from the viewpoint of improving performance such as luminous efficiency and durability. Examples of such layers include a charge transport layer (i.e., a hole transport layer and an electron transport layer), a charge block layer (i.e., a hole block layer and an electron block layer), a charge injection layer (i.e., a hole injection layer and an electron injection layer) and a buffer layer. In this context, in the light-emitting device of the present invention, the light-emitting layer, the charge transport layer, the charge block layer, the charge injection layer, the buffer layer, and the like may respectively be single-layered or double- or more layered.
The light-emitting layer is a layer having the function of emitting light. The hole transport layer is a layer having the function of transporting holes. The electron transport layer is a layer having the function of transporting electrons. These electron transport and hole transport layers are collectively referred to as a charge transport layer. Moreover, the charge block layer is a layer having the function of trapping holes or electrons into the light-emitting layer and is classified into a hole block layer which is a layer for transporting electrons and trapping holes and into an electron block layer which is a layer for transporting holes and trapping electrons.
Examples of the buffer layer include a layer which is located adjacently to the anode and comprises a conductive polymer.
Specific examples of the light-emitting device of the present invention include the following structures a) to q):

a) anode/light-emitting layer/cathode;
b) anode/hole transport layer/light-emitting layer/cathode;
c) anode/light-emitting layer/electron transport layer/cathode;
d) anode/light-emitting layer/hole block layer/cathode;
e) anode/hole transport layer/light-emitting layer/electron transport layer/cathode;
f) anode/charge injection layer/light-emitting layer/cathode;
g) anode/light-emitting layer/charge injection layer/cathode;
h) anode/charge injection layer/light-emitting layer/charge injection layer/cathode;
i) anode/charge injection layer/hole transport layer/light-emitting layer/cathode;
j) anode/hole transport layer/light-emitting layer/charge injection layer/cathode;
k) anode/charge injection layer/hole transport layer/light-emitting layer/charge injection layer/cathode;
l) anode/charge injection layer/light-emitting layer/electron transport layer/cathode;
m) anode/light-emitting layer/electron transport layer/charge injection layer/cathode;
n) anode/charge injection layer/light-emitting layer/electron transport layer/charge injection layer/cathode;
o) anode/charge injection layer/hole transport layer/light-emitting layer/electron transport layer/cathode;
p) anode/hole transport layer/light-emitting layer/electron transport layer/charge injection layer/cathode; and
q) anode/charge injection layer/hole transport layer/light-emitting layer/electron transport layer/charge injection layer/cathode.

In this context, the symbol/represents that the layers described before and after the symbol are stacked adjacently to each other. The same holds true for description below. In this context, the light-emitting layer, the hole transport layer and the electron transport layer may each independently be double- or more layered for use.

When the light-emitting device of the present invention has a hole transport layer (usually, the hole transport layer contains a hole transport material), materials known in the art can be mentioned as the hole transport material. Examples thereof include polymer hole transport materials such as polyvinylcarbazole and derivatives thereof, polysilane and derivatives thereof, polysiloxane derivatives having aromatic amine in the side chain or the main chain, pyrazoline derivatives, arylamine derivatives, stilbene derivatives, triphenyldiamine derivatives, polyaniline and derivatives thereof, polythiophene and derivatives thereof, polypyrrole and derivatives thereof, poly(p-phenylene vinylene) and derivatives thereof, poly(2,5-thienylene vinylene) and derivatives thereof. Furthermore, the materials described in JP-A-63-70257, JP-A-63-175860, JP-A-2-135359, JP-A-2-135361, JP-A-2-209988, JP-A-3-37992 and JP-A-3-152184 are also included.

When the light-emitting device of the present invention has an electron transport layer (usually, the electron transport layer contains an electron transport material), materials known in the art can be mentioned as the electron transport material. Examples thereof include oxadiazole derivatives, anthraquinodimethane and derivatives thereof, benzoquinone and derivatives thereof, naphthoquinone and derivatives thereof, anthraquinone and derivatives thereof, tetracyanoanthraquinodimethane and derivatives thereof, fluorenone derivatives, diphenyldicyanoethylene and derivatives thereof, diphenoquinone derivatives, metal complexes of 8-hydroxyquinoline and derivatives thereof, polyquinoline and derivatives thereof, polyquinoxaline and derivatives thereof, polyfluorene and derivatives thereof.

The film thicknesses of the hole transport layer and the electron transport layer differ in optimum value depending on materials used and need only to be selected to offer appropriate values of a drive voltage and luminous efficiency. These layers require at least a thickness that prevents pinhole formation. Too thick a film thickness is not preferable, because a high drive voltage for the device is required. Thus, the hole transport layer and the electron transport layer have a film thickness of, for example, 1 nm to 1 $\mu$m, preferably 2 nm to 500 nm, more preferably 5 nm to 200 nm.

Moreover, of the charge transport layers disposed adjacently to the electrode, those having the function of improving charge injection efficiency from the electrode and the effect of decreasing a drive voltage for the device may particularly be called a charge injection layer (i.e., a general term for a hole injection layer and an electron injection layer; the same holds true for description below).

Furthermore, the charge injection layer or an insulating layer (usually, 0.5 nm to 4 nm in average film thickness; the same holds true for description below) may be disposed adjacently to the electrode for improving adhesion to the electrode and charge injection from the electrode. Moreover, a thin buffer layer may be inserted in the interface of the charge transport layer or the light-emitting layer for, for example, improving adhesion of the interface or preventing contamination.

The order in which layers are stacked, the number of layers, and the thickness of each layer can be selected appropriately in consideration of luminous efficiency and a device lifetime.

Specific examples of the charge injection layer include: a layer comprising a conductive polymer; a layer which is disposed between the anode and the hole transport layer and comprises a material having an ionization potential intermediate between the corresponding values of the anode material and the hole transport material contained in the hole transport layer; and a layer which is disposed between the cathode and the electron transport layer and comprises a material having electron affinity intermediate between the corresponding values of the cathode material and the electron transport material contained in the electron transport layer.

The material used in the charge injection layer needs only to be selected appropriately according to the relationship with the materials for the electrode or the adjacent layer and is exemplified by polyaniline and derivatives thereof, polythiophene and derivatives thereof, polypyrrole and derivatives thereof, polyphenylene vinylene and derivatives thereof, polythienylene vinylene and derivatives thereof, polyquinoline and derivatives thereof, polyquinoxaline and derivatives thereof, conductive polymers (e.g., polymers containing an aromatic amine structure in the main chain or the side chain), metallophthalocyanine (e.g., copper phthalocyanine) and carbon.

The insulating layer has the function of facilitating charge injection. Examples of materials for the insulating layer include metal fluorides, metal oxides and organic insulating materials. Examples of the light-emitting device comprising the insulating layer include: a light-emitting device comprising the insulating layer disposed adjacently to the cathode; and a light-emitting device comprising the insulating layer disposed adjacently to the anode.

The light-emitting device of the present invention is usually formed on a substrate. The substrate is any of those not changing when the electrode and subsequently the organic layer are formed thereon. Examples thereof include glass, plastic, polymer films and silicon substrates. When an opaque substrate is used, it is preferred that the electrode on the other side should be transparent or semitransparent.

At least one of the anode and the cathode contained in the light-emitting device of the present invention is usually transparent or semitransparent. Particularly, it is preferred that the anode should be transparent or semitransparent.

Materials known in the art can be selected appropriately and used as materials for the anode. Conductive metal

oxide films, semitransparent metal thin films, or the like are usually used. Examples thereof specifically include a film (NESA, etc.) prepared using conductive glass comprising indium oxide, zinc oxide, tin oxide and their complex indium tin oxide (ITO) or indium zinc oxide, and the like. Gold, platinum, silver, copper, or the like is also used. ITO, indium zinc oxide and tin oxide are preferable. Examples of the preparation method include vacuum deposition, sputtering, ion plating and plating methods. Alternatively, transparent organic conductive films such as polyaniline or derivatives thereof and polythiophene or derivatives thereof may be used as the anode. In this context, the anode may have a double-or more layered structure.

Materials known in the art can be selected appropriately and used as materials for the cathode. Materials having a small work function are usually preferable as materials for the cathode. For example, metals such as lithium, sodium, potassium, rubidium, cesium, beryllium, magnesium, calcium, strontium, barium, aluminum, scandium, vanadium, zinc, yttrium, indium, cerium, samarium, europium, terbium and ytterbium, and alloys of two ore more thereof or alloys of one or more thereof with one or more of gold, silver, platinum, copper, manganese, titanium, cobalt, nickel, tungsten and tin, and graphite or intercalated graphite are used. Specific examples of the alloys include magnesium-silver, magnesium-indium, magnesium-aluminum, indium-silver, lithium-aluminum, lithium-magnesium, lithium-indium and calcium-aluminum alloys. In this context, the cathode may have a double- or more layered structure.

The light-emitting device of the present invention can be used, for example, in a planar light source and a display device (for example, a segment display device, a dot matrix display device, a liquid-crystal display device, etc.) or as a backlight thereof (for example, a liquid-crystal display device comprising the light-emitting device as a backlight).

To obtain planar light emission using the light-emitting device of the present invention, planar anode and cathode need only to be arranged such that they overlap with each other. Moreover, to obtain patterned light emission, methods are used which include: a method comprising placing a mask provided with a window with the pattern on the surface of the planar light-emitting device; a method comprising forming an extremely thick organic layer of a non-light-emitting portion such that the portion becomes substantially non-light-emitting; and a method comprising forming the pattern on either of the anode and the cathode or both of the electrodes. The pattern is formed by any of these methods, and some electrodes are arranged such that they can independently be switched between the ON and OFF positions. As a result, a segment-type display device is obtained which can display numbers, letters, simple symbols, and so on. Furthermore, to obtain a dot matrix device, both the anode and cathode need only to be formed in a striped form and arranged orthogonally. Partial color display or multicolor display is achieved by a method comprising separately applying a plurality of types of polymer phosphors differing in the color of emitted light or by a method using a color filter or a fluorescence conversion filter. The dot matrix device can be driven passively or may be driven actively in combination with TFT or the like. These display devices can be used as display devices for computers, televisions, mobile terminals, cellular phones, car navigation systems, video camera view finders, and so on.

Furthermore, the planar light-emitting device is usually a self-emitting, thin device and can be used preferably, for example, as a planar light source for backlights in liquid-crystal display devices or as illumination (e.g., planar illumination or a light source for the illumination). Moreover, the planar light-emitting device can be used as a light source, illumination, a display device, etc., having a curved surface, when a flexible substrate is used therein.

As described above, the composition, etc., of the present invention are not only useful in the preparation of devices but also can be used, for example, as a semiconductor material (e.g., an organic semiconductor material), a light-emitting material, an optical material or a conductive material (e.g., which is applied by doping). Thus, the composition, etc., of the present invention can be used to prepare films such as light-emitting thin films, conductive thin films and organic semiconductor thin films.

The composition, etc., of the present invention can be used to form conductive thin films and semiconductor thin films and make them into devices in the same way as in the method for preparing a light-emitting thin film used as the light-emitting layer in the light-emitting device. For the semiconductor thin films, it is preferred that, of electron mobility and hole mobility, the larger one should have $10^{-5}$ $cm^2/V/second$ or larger. Moreover, the organic semiconductor thin films can be used in organic solar cells, organic transistors, and so on.

## EXAMPLES

Hereinafter, the present invention will be described more specifically with reference to Examples. However, the present invention is not intended to be limited to them.

<Example 1>

A polymer (P-1) represented by the following formula:

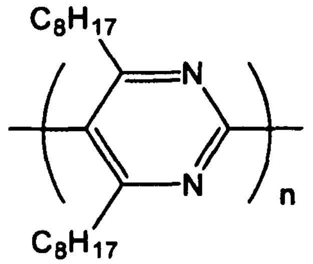

(P－1)

wherein n is the degree of polymerization,
had the lowest triplet excitation energy $T_1$ (1/n=0) of 3.7 eV as an extrapolated value at n=∞, an absolute value of the lowest unoccupied molecular orbital energy level $E_{LUMO}$ (1/n=0) of 2.0 eV, and the smallest dihedral angle of 67°.

The parameter calculation was conducted by a computational chemical approach described in Detailed Description of the Invention. Specifically, the structure was optimized according to an HF method by simplifying the following repeating unit (M-1) in the polymer (P-1) to the structure (M-1a) wherein n=1, 2 and 3:

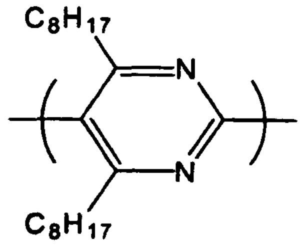

(M－1)

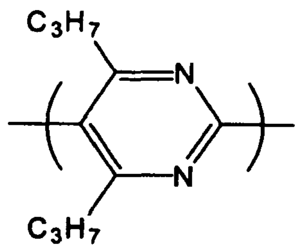

(M－1a)

In this procedure, 6-31G* was used as a basis function. Then, the lowest unoccupied molecular orbital energy level and the lowest triplet excitation energy were calculated by a time-dependent density functional method at a B3P86 level using the same basis. The lowest unoccupied molecular orbital energy level and the lowest triplet excitation energy calculated at each n were used as a function of the reciprocal of n, (1/n), while the extrapolated value at n=∞ was used as a value at 1/n=0 of the function.
The validity of the simplified chemical structure was confirmed according to a method described in JP-A-2005-126686 based on the small alkyl side chain length dependence of the lowest triplet excitation energy and the lowest unoccupied molecular orbital energy level (the same holds true for Example 2, Example 3 and Comparative Example 1).
Moreover, the dihedral angle was calculated from the optimized structure of a structure wherein n=3 (n is the degree of polymerization). The compound has a plurality of the pyrimidine ring structures and therefore also has a plurality of the dihedral angles. In this Example, only the lowest value among the plurality of the dihedral angles is described (hereinafter, the same holds true for Example 2, Example 3 and Comparative Example 1).

A light-emitting device prepared using a composition comprising the polymer (P-1) and a phosphorescence-emitting compound can be confirmed to be excellent in luminous efficiency.

<Example 2>

A polymer (P-2) represented by the following formula:

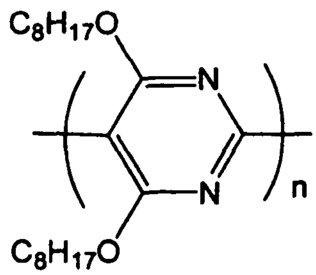

(P－2)

wherein n is the degree of polymerization,

had the lowest triplet excitation energy $T_1$ (1/n=0) of 3.6 eV as an extrapolated value at n=∞, an absolute value of the lowest unoccupied molecular orbital energy level $E_{LUMO}$ (1/n=0) of 1.5 eV, and the smallest dihedral angle of 70°. The parameter calculation was conducted in the same way as in Example 1 by simplifying the following repeating unit (M-2) in the polymer (P-2) to the structure (M-2a):

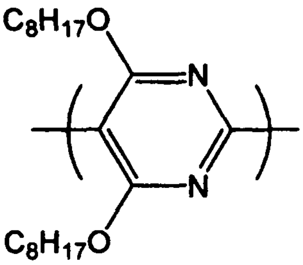

(M−2)

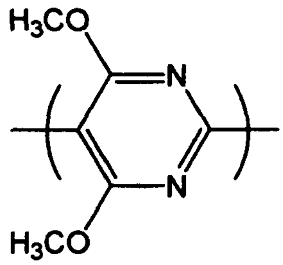

(M−2a)

A light-emitting device prepared using a composition comprising the polymer (P-2) and a phosphorescence-emitting compound can be confirmed to be excellent in luminous efficiency.

<Example 3>

A polymer (P-3) represented by the following formula:

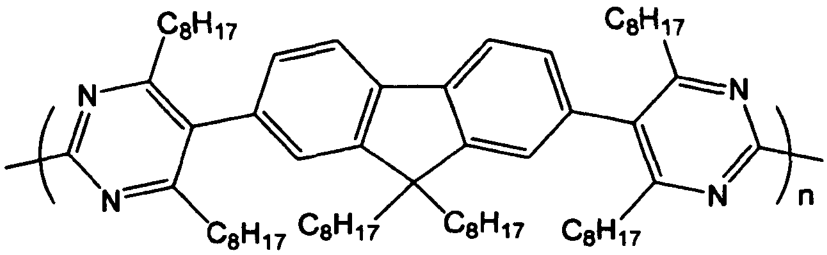

**(P-3)**

wherein n represents the degree of polymerization,
had the lowest triplet excitation energy $T_1$ (1/n=0) of 3.1 eV as an extrapolated value at n=∞ and an absolute value of the lowest unoccupied molecular orbital energy level $E_{LUMO}$ (1/n=0) of 1.8 eV, and the smallest dihedral angle of 44°. The parameter calculation was conducted in the same way as in Example 1 by simplifying the repeating unit (M-3) shown below in the polymer (P-3) to the structure (M-3a).

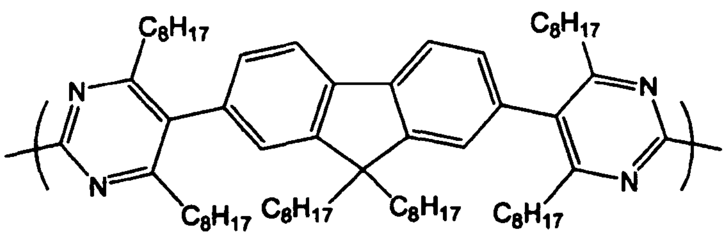

**(M-3)**

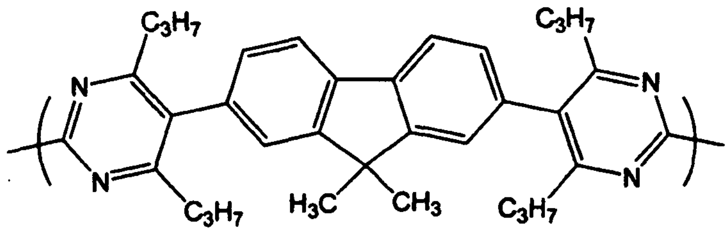

**(M-3a)**

A light-emitting device prepared using a composition comprising the polymer (P-3) and a phosphorescence-emitting compound can be confirmed to be excellent in luminous efficiency.

<Comparative Example 1>

A polymer (P-4) represented by the following formula:

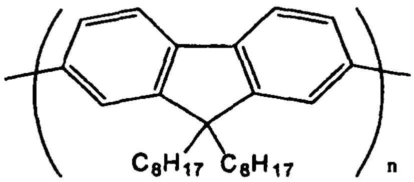

(P-4)

wherein n represents the degree of polymerization,
had the lowest triplet excitation energy $T_1$ (1/n=0) of 2.6 eV as an extrapolated value at n=∞ and an absolute value of the lowest unoccupied molecular orbital energy level $E_{LUMO}$ (1/n=0) of 2.1 eV, and the smallest dihedral angle of 45°. The parameter calculation was conducted in the same way as in Example 1 by simplifying the repeating unit (M-4) shown below in the polymer (P-4) to the structure (M-4a).

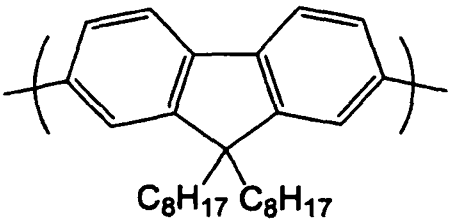

(M-4)

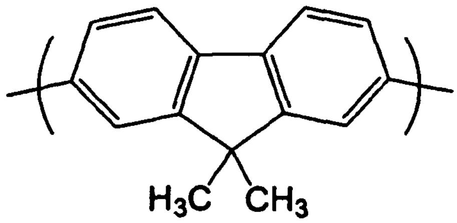

(M-4a)

<Reference Example 4>

A 0.05 wt% THF solution of a phosphorescence-emitting compound (MC-1) represented by the following formula:

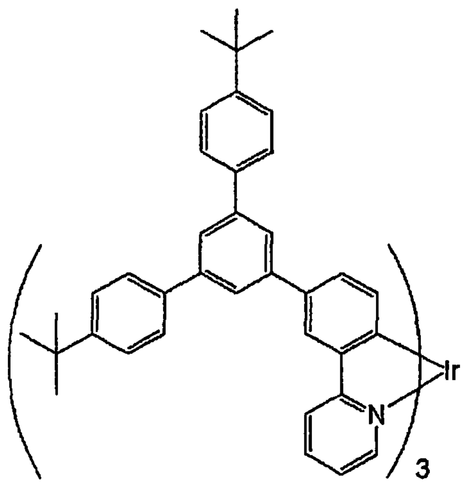

(MC-1)

was mixed with an approximately 5-fold weight of an approximately 1 wt% THF solution of a compound represented by the following formula (C-1):

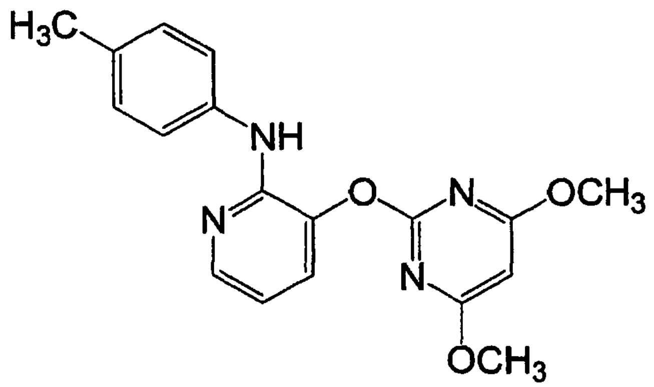

(C-1)

A 10 μl aliquot of the obtained solution was added dropwise to a slide glass and dried in air to obtain a solid film. This film was irradiated with UV rays at 365 nm. As a result, green light emission from the phosphorescence-emitting compound (MC-1) was confirmed.
The compound represented by the formula (C-1) had the lowest triplet excitation energy $T_1$ of 3.3 eV and an absolute value of the lowest unoccupied molecular orbital energy level $E_{LUMO}$ of 1.1 eV.
In this context, the compound represented by the formula (6-1) was synthesized according to a method described in JP-A-2004-292432. Moreover, the compound represented by the formula (MC-1) was synthesized according to a method described in WO02/066552.

<Reference Example 5>

A 0.05 wt% THF solution of the phosphorescence-emitting compound (MC-1) was mixed with an approximately 5-fold weight of an approximately 1 wt% THF solution of a compound represented by the following formula (C-2):

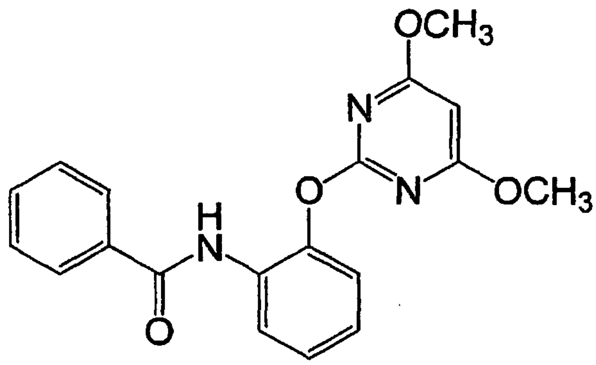

(C-2)

A 10 μl aliquot of the obtained solution was added dropwise to a slide glass and dried in air to obtain a solid film. This film was irradiated with UV rays at 365 nm. As a result, green light emission from the phosphorescence-emitting compound (MC-1) was confirmed.
The compound represented by the formula (C-2) had the lowest triplet excitation energy $T_1$ of 3.5 eV and an absolute value of the lowest unoccupied molecular orbital energy level $E_{LUMO}$ of 1.6 eV.

<Reference Example 6>

A 0.05 wt% THF solution of the phosphorescence-emitting compound (MC-1) was mixed with an approximately 5-fold weight of an approximately 1 wt% THF solution of a compound represented by the following formula (C-3):

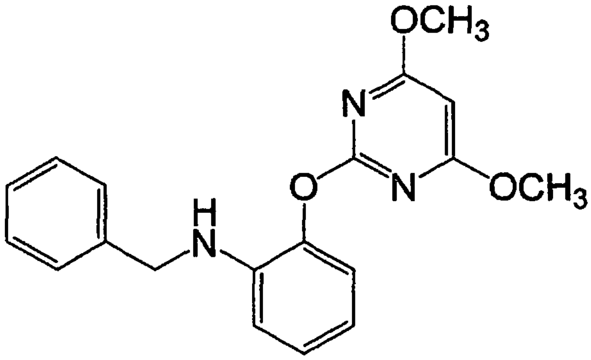

(C-3)

A 10 μl aliquot of the obtained solution was added dropwise to a slide glass and dried in air to obtain a solid film. This film was irradiated with UV rays at 365 nm. As a result, green light emission from the phosphorescence-emitting compound (MC-1) was confirmed.

<Reference Example 8>

A 0.05 wt% THF solution of the phosphorescence-emitting compound (MC-1) was mixed with an approximately 5-fold weight of an approximately 1 wt% THF solution of a compound represented by the following formula (C-4):

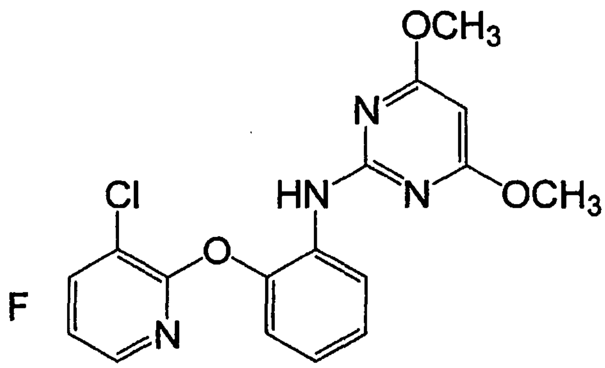

(C-4)

A 10 μl aliquot of the obtained solution was added dropwise to a slide glass and dried in air to obtain a solid film. This film was irradiated with UV rays at 365 nm. As a result, green light emission from the phosphorescence-emitting compound (MC-1) was confirmed.
The compound represented by the formula (C-4) had the lowest triplet excitation energy $T_1$ of 3.5 eV and an absolute value of the lowest unoccupied molecular orbital energy level $E_{LUMO}$ of 1.9 eV.

<Reference Example 9>

A 0.05 wt% THF solution of the phosphorescence-emitting compound (MC-1) was mixed with an approximately 5-fold weight of an approximately 1 wt% THF solution of a compound represented by the following formula (C-5):

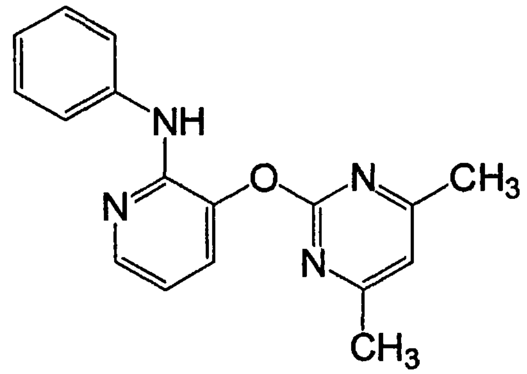

(C-5)

A 10 μl aliquot of the obtained solution was added dropwise to a slide glass and dried in air to obtain a solid film. This film was irradiated with UV rays at 365 nm. As a result, green light emission from the phosphorescence-emitting compound (MC-1) was confirmed.
The compound represented by the formula (C-5) had the lowest triplet excitation energy $T_1$ of 3.3 eV and an absolute value of the lowest unoccupied molecular orbital energy level $E_{LUMO}$ of 1.7 eV.

<Reference Example 10>

A 0.05 wt% THF solution of the phosphorescence-emitting compound (MC-1) was mixed with an approximately 5-fold weight of an approximately 1 wt% THF solution of a compound represented by the following formula (C-6):

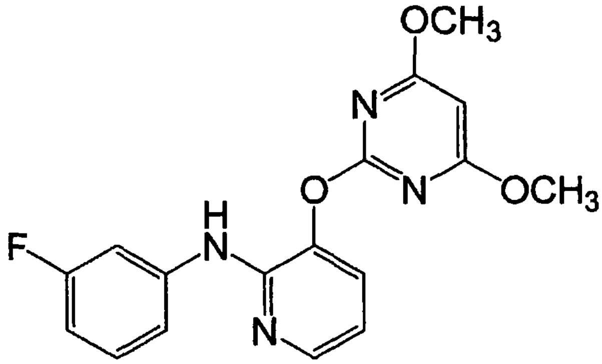

(C-6)

A 10 μl aliquot of the obtained solution was added dropwise to a slide glass and dried in air to obtain a solid film. This film was irradiated with UV rays at 365 nm. As a result, green light emission from the phosphorescence-emitting compound (MC-1) was confirmed.

<Reference Example 11>

A 0.05 wt% THF solution of the phosphorescence-emitting compound (MC-1) was mixed with an approximately 5-fold weight of an approximately 1 wt% THF solution of a compound represented by the following formula (C-7):

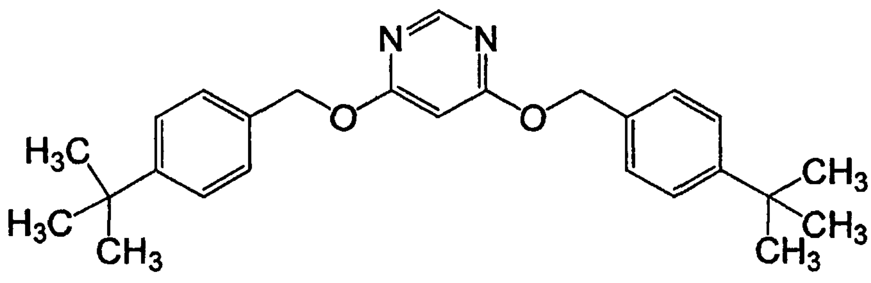

(C-7)

A 10 μl aliquot of the obtained solution was added dropwise to a slide glass and dried in air to obtain a solid film. This

film was irradiated with UV rays at 365 nm. As a result, green light emission from the phosphorescence-emitting compound (MC-1) was confirmed.

<Reference Example 12>

A 0.05 wt% THF solution of the phosphorescence-emitting compound (MC-1) was mixed with an approximately 5-fold weight of an approximately 1 wt% THF solution of a compound represented by the following formula (C-8):

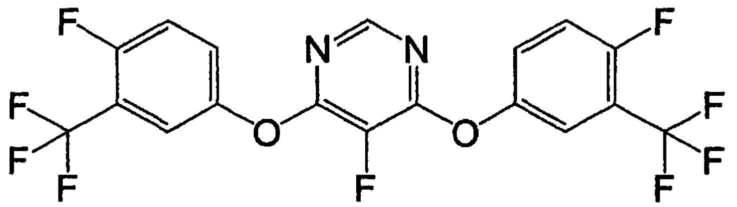

(C-8)

A 10 $\mu$l aliquot of the obtained solution was added dropwise to a slide glass and dried in air to obtain a solid film. This film was irradiated with UV rays at 365 nm. As a result, green light emission from the phosphorescence-emitting compound (MC-1) was confirmed.
The compound represented by the formula (C-8) had the lowest triplet excitation energy $T_1$ of 3.8 eV and an absolute value of the lowest unoccupied molecular orbital energy level $E_{LUMO}$ of 1.9 eV.

<Reference Example 13>

A 0.05 wt% THF solution of the phosphorescence-emitting compound (MC-1) was mixed with an approximately 5-fold weight of an approximately 1 wt% THF solution of a compound represented by the following formula (C-9):

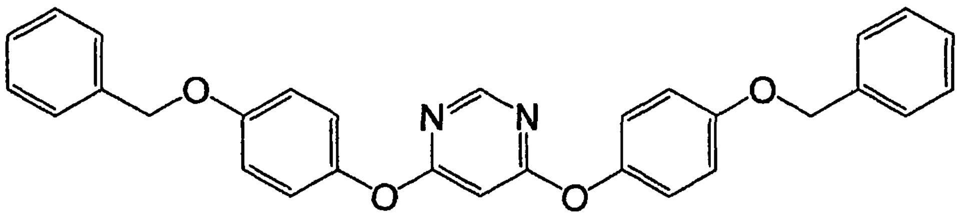

(C-9)

A 10 $\mu$l aliquot of the obtained solution was added dropwise to a slide glass and dried in air to obtain a solid film. This film was irradiated with UV rays at 365 nm. As a result, green light emission from the phosphorescence-emitting compound (MC-1) was confirmed.

<Reference Example 14>

A 0.05 wt% THF solution of the phosphorescence-emitting compound (MC-1) was mixed with an approximately 5-fold weight of an approximately 1 wt% THF solution of a compound represented by the following formula (C-10):

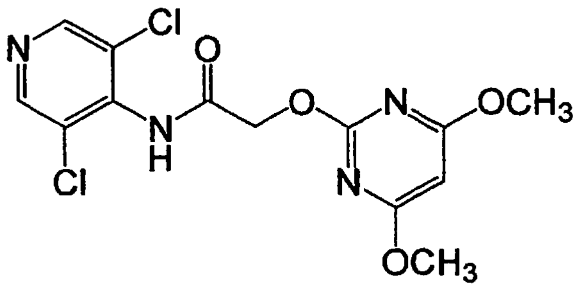

(C-10)

A 10 $\mu$l aliquot of the obtained solution was added dropwise to a slide glass and dried in air to obtain a solid film. This film was irradiated with UV rays at 365 nm. As a result, green light emission from the phosphorescence-emitting compound (MC-1) was confirmed.

The compound represented by the formula (C-10) had the lowest triplet excitation energy $T_1$ of 3.7 eV and an absolute value of the lowest unoccupied molecular orbital energy level $E_{LUMO}$ of 1.9 eV.

<Reference Example 15>

A 0.05 wt% THF solution of the phosphorescence-emitting compound (MC-1) was mixed with an approximately 5-fold weight of an approximately 1 wt% THF solution of a compound represented by the following formula (C-11):

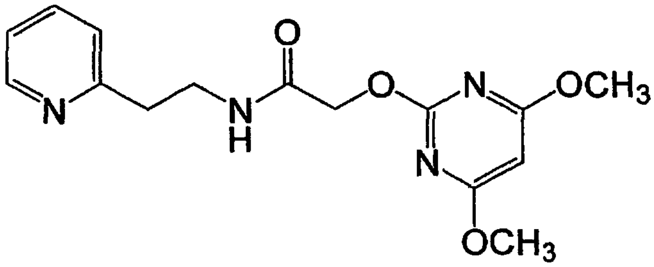

(C-11)

A 10 μl aliquot of the obtained solution was added dropwise to a slide glass and dried in air to obtain a solid film. This film was irradiated with UV rays at 365 nm. As a result, green light emission from the phosphorescence-emitting compound (MC-1) was confirmed.

<Reference Example 16>

A 0.05 wt% THF solution of the phosphorescence-emitting compound (MC-1) was mixed with an approximately 5-fold weight of an approximately 1 wt% THF solution of a compound represented by the following formula (C-12):

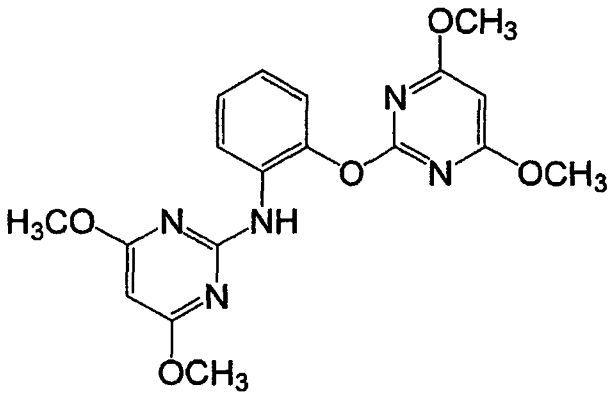

(C-12)

A 10 μl aliquot of the obtained solution was added dropwise to a slide glass and dried in air to obtain a solid film. This film was irradiated with UV rays at 365 nm. As a result, green light emission from the phosphorescence-emitting compound (MC-1) was confirmed.

<Reference Example 17>

A 0.05 wt% THF solution of the phosphorescence-emitting compound (MC-1) was mixed with an approximately 5-fold weight of an approximately 1 wt% THF solution of a compound represented by the following formula (C-13):

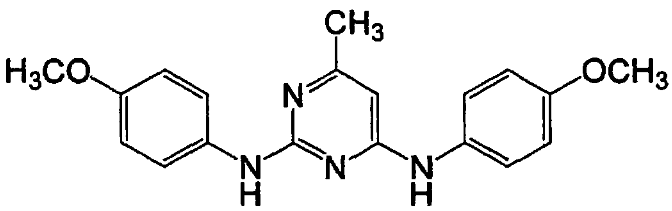

(C-13)

A 10 μl aliquot of the obtained solution was added dropwise to a slide glass and dried in air to obtain a solid film. This film was irradiated with UV rays at 365 nm. As a result, green light emission from the phosphorescence-emitting compound (MC-1) was confirmed.

<Reference Example 18>

A 0.05 wt% THF solution of the phosphorescence-emitting compound (MC-1) was mixed with an approximately 5-fold weight of an approximately 1 wt% THF solution of a compound represented by the following formula (C-14):

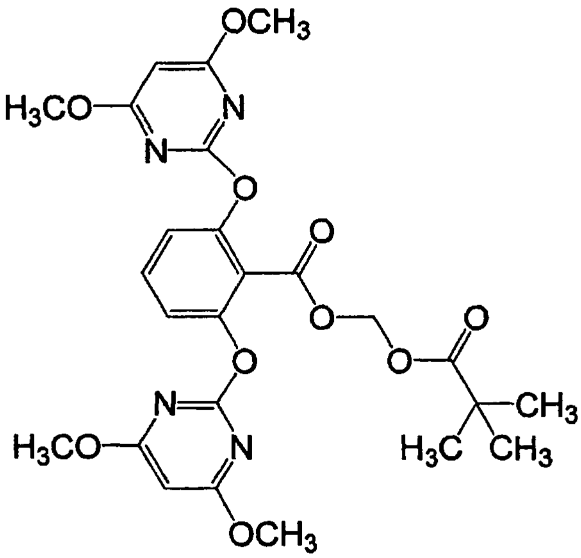

(C-14)

A 10 μl aliquot of the obtained solution was added dropwise to a slide glass and dried in air to obtain a solid film. This film was irradiated with UV rays at 365 nm. As a result, green light emission from the phosphorescence-emitting compound (MC-1) was confirmed.

<Reference Example 19>

A 0.05 wt% THF solution of the phosphorescence-emitting compound (MC-1) was mixed with an approximately 5-fold weight of an approximately 1 wt% THF solution of a compound represented by the following formula (C-15):

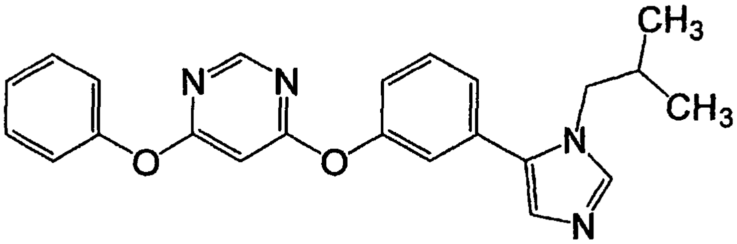

(C-15)

A 10 μl aliquot of the obtained solution was added dropwise to a slide glass and dried in air to obtain a solid film. This film was irradiated with UV rays at 365 nm. As a result, green light emission from the phosphorescence-emitting compound (MC-1) was confirmed.

<Reference Example 20>

A 0.05 wt% THF solution of the phosphorescence-emitting compound (MC-1) was mixed with an approximately 5-fold weight of an approximately 1 wt% THF solution of a compound represented by the following formula (C-16):

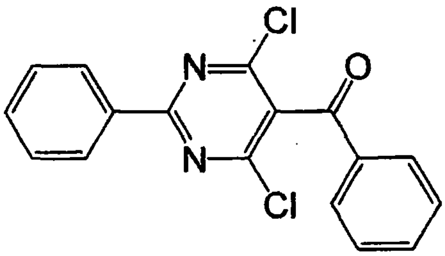

(C-16)

A 10 μl aliquot of the obtained solution was added dropwise to a slide glass and dried in air to obtain a solid film. This film was irradiated with UV rays at 365 nm. As a result, green light emission from the phosphorescence-emitting compound (MC-1) was confirmed.
The compound represented by the formula (C-16) had the lowest triplet excitation energy $T_1$ of 3.1 eV and an absolute value of the lowest unoccupied molecular orbital energy level $E_{LUMO}$ of 2.5 eV.

<Reference Example 21>

A 0.05 wt% THF solution of the phosphorescence-emitting compound (MC-1) was mixed with an approximately 5-fold weight of an approximately 1 wt% THF solution of a compound represented by the following formula (C-17):

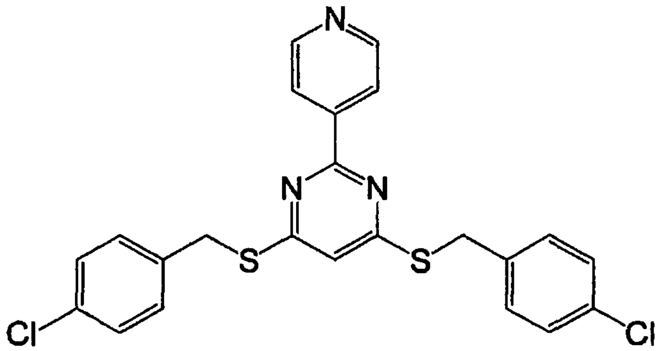

(C-17)

A 10 μl aliquot of the obtained solution was added dropwise to a slide glass and dried in air to obtain a solid film. This film was irradiated with UV rays at 365 nm. As a result, green light emission from the phosphorescence-emitting compound (MC-1) was confirmed.
The compound represented by the formula (C-17) had the lowest triplet excitation energy $T_1$ of 3.2 eV and an absolute value of the lowest unoccupied molecular orbital energy level $E_{LUMO}$ of 2.5 eV.

<Example 22>

A 0.05 wt% THF solution of the phosphorescence-emitting compound (MC-1) was mixed with an approximately 5-fold weight of an approximately 1 wt% THF solution of a compound represented by the following formula (C-18):

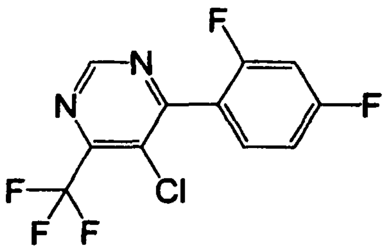

(C-18)

A 10 μl aliquot of the obtained solution was added dropwise to a slide glass and dried in air to obtain a solid film. This film was irradiated with UV rays at 365 nm. As a result, green light emission from the phosphorescence-emitting compound (MC-1) was confirmed.

The compound represented by the formula (C-18) had the lowest triplet excitation energy $T_1$ of 3.6 eV, an absolute value of the lowest unoccupied molecular orbital energy level $E_{LUMO}$ of 2.7 eV, and the smallest dihedral angle of 61°.

<Example 23>

A 0.05 wt% THF solution of the phosphorescence-emitting compound (MC-1) was mixed with an approximately 5-fold weight of an approximately 1 wt% THF solution of a compound represented by the following formula (C-19):

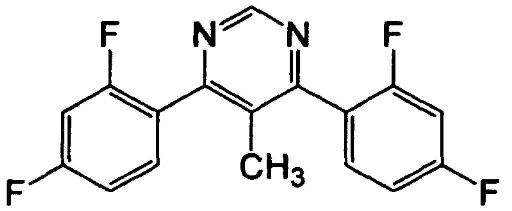

(C-19)

A 10 μl aliquot of the obtained solution was added dropwise to a slide glass and dried in air to obtain a solid film. This film was irradiated with UV rays at 365 nm. As a result, green light emission from the phosphorescence-emitting compound (MC-1) was confirmed.
The compound represented by the formula (C-19) had the lowest triplet excitation energy $T_1$ of 3.6 eV, an absolute value of the lowest unoccupied molecular orbital energy level $E_{LUMO}$ of 2.0 eV, and the smallest dihedral angle of 50°.

<Example 24>

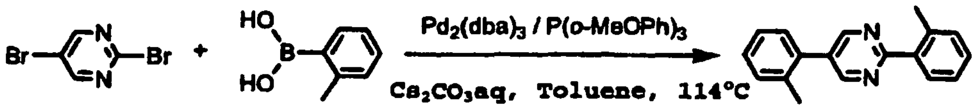


(C-20)

A mixture of 2,5-dibromopyrimidine (SynChem Inc.) (1.01 g, 4.2 mmol), o-methylbenzeneboronic acid (Wako Pure Chemical Industries, Ltd.) (1.39 g, 10 mmol), anisole (0.5 g) and toluene (62.8 mL) was added to tris(dibenzylideneacetone)dipalladium (Sigma-Aldrich, Inc.) (11.4 mg, 0.012 mmol) and tris(2-methoxyphenyl)phosphine (Lancaster Synthesis Ltd.) (36.0 mg, 0.10 mmol) in an inert gas atmosphere. A 33 wt% aqueous cesium carbonate solution (42.0 mL) was added thereto, and the mixture was reacted at 114°C for approximately 9 hours with stirring. After cooling to room temperature, the aqueous layer was removed. The organic layer was washed with distilled water and then dried over anhydrous sodium sulfate, and the filtrate was concentrated. The crude product was purified by silica gel column chromatography, concentrated, and dried to obtain the compound (C-20) (1.08 g, 4.1 mmol, yield: 97%).

<Example 25>

A film of a suspension of poly(3,4)ethylenedioxythiophene/polystyrene sulfonic acid (manufactured by Bayer AG, trade name: Baytron P AI4083) was formed as a hole injection layer at a thickness of 65 nm by spin coating on a glass substrate coated with an ITO film at a thickness of 150 nm by a sputtering method. The film was dried at 200°C for 10 minutes on a hot plate. Next, the compound (C-20) thus obtained was dissolved at a concentration of 3.5 wt% in xylene. The phosphorescence-emitting compound (MC-1) was also dissolved as a phosphorescence-emitting material at a concentration of 3.5 wt% in xylene. Moreover, a polymer represented by the formula (PP-1) shown below was also dissolved at a concentration of 3.5 wt% in xylene. Furthermore, the compound (C-20) thus obtained, the phosphorescence-emitting compound (MC-1) and the polymer (PP-1) were mixed at a weight ratio of 20/30/50 to prepare a solution. This mixed solution was applied onto the hole injection layer by spin coating at 2500 rpm. This light-emitting layer had a film thickness of approximately 80 nm. Then, the film was dried at 90°C for 10 minutes in a nitrogen atmosphere containing 10 ppm or lower moisture and oxygen concentrations. Then, barium (approximately 5 nm) and subsequently aluminum (approximately 100 nm) were deposited as a cathode to prepare an EL device. The device comprises ITO/Baytron P (65 nm)/(compound (C-20)/phosphorescence-emitting compound (MC-1)/polymer (PP-1)=20/30/50 (80 nm))/Ba/Al. In this context, the metal deposition was started after the degree of vacuum reached $1x10^{-4}$ Pa or lower.
A voltage was applied to the obtained device. As a result, the device exhibited green light emission with a peak wavelength of 520 nm derived from the phosphorescence-emitting compound (MC-1). This device had the largest luminous efficiency

of 8.4 cd/A.

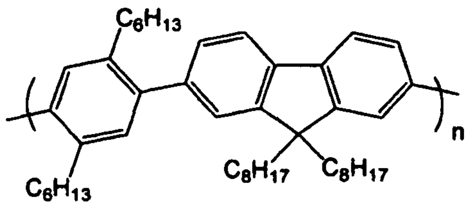

(PP-1)

<Example 26>

A 0.05 wt% THF solution of the phosphorescence-emitting compound (MC-1) was mixed with an approximately 5-fold weight of an approximately 1 wt% THF solution of the compound represented by the formula (C-20). A 10 μl aliquot of the obtained solution was added dropwise to a slide glass and dried in air to obtain a solid film. This film was irradiated with UV rays at 365 nm. As a result, green light emission from the phosphorescence-emitting compound (MC-1) was confirmed.
The compound represented by the formula (C-20) had the lowest triplet excitation energy $T_1$ of 3.3 eV, an absolute value of the lowest unoccupied molecular orbital energy level $E_{LUMO}$ of 1.8 eV, and the smallest dihedral angle of 30°.

<Example 27>

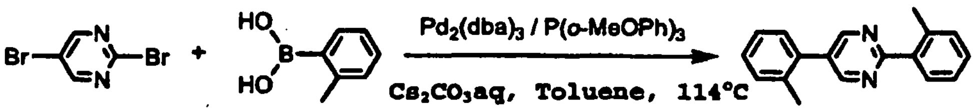


(C-20)

2,5-dibromopyrimidine (SynChem Inc.) (1.00 g, 4.2 mmol), 2,6-dimethylbenzeneboronic acid (Wako Pure Chemical Industries, Ltd.) (1.89 g, 13 mmol), palladium acetate (Sigma-Aldrich, Inc.) (18.8 mg, 0.084 mmol), 2-dicyclohexylphosphino-2'-methylbiphenyl (STREM CHEMICALS, INC.) (61.3 mg, 0.17 mmol), potassium phosphate (3.58 g, 17 mmol), anisole (0.5 g) and toluene (18.9 mL) were mixed in an inert gas atmosphere and reacted at 100°C for approximately 17 hours. After cooling to room temperature, the aqueous layer was removed. The organic layer was washed with distilled water and then dried over anhydrous sodium sulfate, and the filtrate was concentrated. The crude product was purified by silica gel column chromatography and concentrated. Then, methanol was added thereto, and the precipitate was collected and dried to obtain the compound (C-21) (0.27 g, 0.9 mmol, yield: 22%).

<Example 28>

A 0.05 wt% THF solution of the phosphorescence-emitting compound (MC-1) was mixed with an approximately 5-fold weight of an approximately 1 wt% THF solution of the compound represented by the formula (C-21). A 10 μl aliquot of the obtained solution was added dropwise to a slide glass and dried in air to obtain a solid film. This film was irradiated with UV rays at 365 nm. As a result, green light emission from the phosphorescence-emitting compound (MC-1) was confirmed.
The compound represented by the formula (C-21) had the lowest triplet excitation energy $T_1$ of 3.6 eV, an absolute value of the lowest unoccupied molecular orbital energy level $E_{LUMO}$ of 1.7 eV, and the smallest dihedral angle of 68°.

<Example 29>

A film of a suspension of poly(3,4)ethylenedioxythiophene/polystyrene sulfonic acid (manufactured by Bayer AG, trade name: Baytron P AI4083) was formed as a hole injection layer at a thickness of 65 nm by spin coating on a glass substrate coated with an ITO film at a thickness of 150 nm by a sputtering method. The film was dried at 200°C for 10 minutes on a hot plate. Next, the compound (C-21) thus obtained was dissolved at a concentration of 3.5 wt% in xylene. The phosphorescence-emitting compound (MC-1) was also dissolved as a phosphorescence-emitting material at a concentration of 3.5 wt% in xylene. Moreover, the polymer represented by the formula (PP-1) was also dissolved at a concentration of 3.5 wt% in xylene. Furthermore, the compound (C-21) thus obtained, the phosphorescence-emitting compound (MC-1) and a polymer (PP-1) were mixed at a weight ratio of 20/30/50 to prepare a solution. This mixed

solution was applied onto the hole injection layer by spin coating at 2500 rpm. This light-emitting layer had a film thickness of approximately 80 nm. Then, the film was dried at 90°C for 10 minutes in a nitrogen atmosphere containing 10 ppm or lower moisture and oxygen concentrations. Then, barium (approximately 5 nm) and subsequently aluminum (approximately 100 nm) were deposited as a cathode to prepare an EL device. The device comprises ITO/Baytron P (65 nm)/(compound (C-21)/phosphorescence-emitting compound (MC-1)/polymer (PP-1)=20/30/50 (80 nm))/Ba/Al. In this context, the metal deposition was started after the degree of vacuum reached $1\times10^{-4}$ Pa or lower.
A voltage was applied to the obtained device. As a result, the device exhibited green light emission with a peak wavelength of 520 nm derived from the phosphorescence-emitting compound (MC-1). This device had the largest luminous efficiency of 19.1 cd/A.

<Example 30>

A film of a suspension of poly(3,4)ethylenedioxythiophene/polystyrene sulfonic acid (manufactured by Bayer AG, trade name: Baytron P AI4083) was formed as a hole injection layer at a thickness of 65 nm by spin coating on a glass substrate coated with an ITO film at a thickness of 150 nm by a sputtering method. The film was dried at 200°C for 10 minutes on a hot plate. Next, the compound (C-21) thus obtained was dissolved at a concentration of 5.0 wt% in xylene. The phosphorescence-emitting compound (MC-1) was also dissolved as a phosphorescence-emitting material at a concentration of 5.0 wt% in xylene. Furthermore, the compound (C-21) thus obtained and the phosphorescence-emitting compound (MC-1) were mixed at a weight ratio of 70/30 to prepare a solution. This mixed solution was applied onto the hole injection layer by spin coating at 600 rpm. This light-emitting layer had a film thickness of approximately 140 nm. Then, the film was dried at 90°C for 10 minutes in a nitrogen atmosphere containing 10 ppm or lower moisture and oxygen concentrations. Then, barium (approximately 5 nm) and subsequently aluminum (approximately 100 nm) were deposited as a cathode to prepare an EL device. The device comprises ITO/Baytron P (65 nm)/(compound (C-21) /phosphorescence-emitting compound (MC-1)=70/30 (140 nm))/Ba/Al. In this context, the metal deposition was started after the degree of vacuum reached $1\times10^{-4}$ Pa or lower.
A voltage was applied to the obtained device. As a result, the device exhibited green light emission with a peak wavelength of 520 nm derived from the phosphorescence-emitting compound (MC-1). This device had the largest luminous efficiency of 1.9 cd/A.

<Example 31>

Synthesis of 7,9-pentadecanonedione

Lithium amide (13.0 g, 498.0 mmol) was dissolved in t-butyl methyl ether (130 ml) in a nitrogen atmosphere, and the solution was heated to 35°C. A t-butyl methyl ether solution (67 ml) of 2-octanone (32.4 g, 252.7 mmol) was added dropwise thereto, and the mixture was stirred for approximately 1 hour. A t-butyl methyl ether solution (67 ml) of ethyl pentanoate (80.0 g, 505.6 mmol) was added dropwise thereto, and the mixture was reacted for approximately 4.5 hours. The mixed reaction solution was cooled, and the reaction was terminated by the addition of ice-cold hydrochloric acid. After extraction with t-butyl methyl ether, the oil phase was dried over sodium sulfate and concentrated. The concentrated residue was dissolved in methanol and added dropwise to an aqueous copper(II) acetate solution heated to 60°C. Then, the mixture was cooled, and the deposited crystal was filtered and washed with petroleum ether to obtain a copper complex of interest. This copper complex was added to a mixed solution of 10% sulfuric acid and t-butyl methyl ether, and the mixture was stirred. The oil phase was collected, dried over sodium sulfate, and concentrated to obtain the compound of interest (36.3 g). Its structure was confirmed by $^1$H NMR.

Synthesis of 4,6-dihexyl-2-hydroxypyrimidine

7,9-pentadecanonedione (60.0 g, 249.6 mmol) and urea (30.0 g, 499.5 mmol) were dissolved in ethanol (3750 mL) in a nitrogen atmosphere. Concentrated hydrochloric acid (75 mL) was added thereto, and the mixture was reacted at approximately 80°C for 19 hours. The reaction mixture was concentrated and washed with water. After extraction with ethyl acetate, the extract was dried over magnesium sulfate and purified on a silica gel column to obtain the compound of interest (31.2 g). Its structure was confirmed by $^1$H NMR.

Synthesis of 5-bromo-4,6-dihexyl-2-hydroxypyrimidine

4,6-dihexyl-2-hydroxypyrimidine (31.2 g, 118.0 mmol) was dissolved in N,N-dimethylformamide (375 mL) in a nitrogen atmosphere. N-bromosuccinimide (21.0 g, 118.0 mmol) was added thereto, and the mixture was reacted at approximately 4°C for approximately 2.5 hours. The reaction mixture was washed with water. After extraction with ethyl

acetate, the extract was dried over magnesium sulfate, recrystallized in ethanol, and purified on a silica gel column to obtain the compound of interest (20.0 g). Its structure was confirmed by $^1$H NMR.

Synthesis of 5-bromo-2-chloro-4,6-dihexylpyrimidine

5-bromo-4,6-dihexyl-2-hydroxypyrimidine (19.6 g, 57.1 mmol) was mixed with N,N-dimethylaniline (2.8 g, 23.1 mmol) and phosphoric acid chloride (40.8, 266.1 mmol) in a nitrogen atmosphere, and the mixture was reacted at 100°C for approximately 2 hours. Phosphoric acid chloride was distilled off under reduced pressure from the reaction mixture, and the residue was washed with water. The oil phase was collected, dried over magnesium sulfate, and purified on a silica gel column to obtain the compound of interest (20.5 g). Its structure was confirmed by $^1$H NMR.

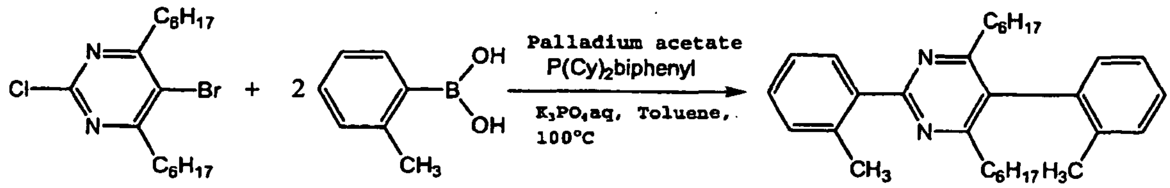


A mixture of 5-bromo-2-chloro-4,6-dihexylpyrimidine (303 mg, 0.83 mmol), o-methylbenzeneboronic acid (Wako Pure Chemical Industries, Ltd.) (330 mg, 2.43 mmol), anisole (53 mg) and toluene (3.2 mL) was added to palladium(II) acetate (Sigma-Aldrich, Inc.) (3.2 mg, 0.014 mmol) and 2-(dicyclohexylphosphino)biphenyl (STREM CHEMICALS, INC.) (12.7 mg, 0.036 mmol) in an inert gas atmosphere. A 2 mol/L aqueous potassium phosphate solution (1.6 mL) was added thereto, and the mixture was reacted at 100°C for approximately 2 hours with stirring. After cooling to room temperature, the aqueous layer was removed. The organic layer was washed with distilled water and then dried over anhydrous sodium sulfate. The filtrate was concentrated and dried to obtain the compound (C-22) (0.4 g). Its structure was confirmed by $^1$H NMR.

MS (manufactured by JEOL Ltd., Accu TOF TLC)

[M+H]+ : 428+1

<Example 32>

A 0.05 wt% THF solution of the phosphorescence-emitting compound (MC-1) was mixed with an approximately 5-fold weight of an approximately 1 wt% THF solution of the compound represented by the formula (C-22). A 10 μl aliquot of the obtained solution was added dropwise to a slide glass and dried in air to obtain a solid film. This film was irradiated with UV rays at 365 nm. As a result, green light emission from the phosphorescence-emitting compound (MC-1) was confirmed.

<Reference Example 33>

A solution was prepared in the same way as in Reference Example 6 except that a phosphorescence-emitting compound (MC-2) shown below was used instead of the phosphorescence-emitting compound (MC-1) in Reference Example 6. The solution was irradiated with UV rays with wavelength of 254 nm. As a result, light emission from the phosphorescence-emitting compound (MC-2, manufactured by American Dye Source, Inc., trade name: ADS065BE) was confirmed.

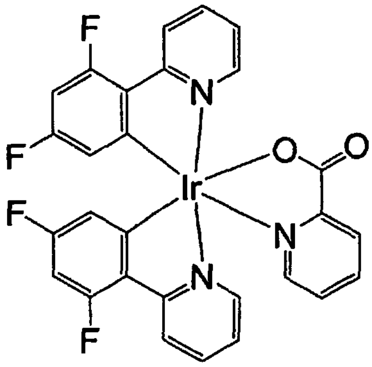

(MC-2)

<Reference Example 34>

A solution was prepared in the same way as in Reference Example 14 except that the phosphorescence-emitting compound (MC-2) shown below was used instead of the phosphorescence-emitting compound (MC-1) in Reference Example 14. The solution was irradiated with UV rays with wavelength of 365 nm. As a result, light emission from the phosphorescence-emitting compound (MC-2) was confirmed.

<Reference Example 35>

A solution was prepared in the same way as in Reference Example 15 except that the phosphorescence-emitting compound (MC-2) shown below was used instead of the phosphorescence-emitting compound (MC-1) in Reference Example 15. The solution was irradiated with UV rays with wavelength of 254 nm. As a result, light emission from the phosphorescence-emitting compound (MC-2) was confirmed.

<Reference Example 36>

A solution was prepared in the same way as in Reference Example 16 except that the phosphorescence-emitting compound (MC-2) shown below was used instead of the phosphorescence-emitting compound (MC-1) in Reference Example 16. The solution was irradiated with UV rays with wavelength of 365 nm. As a result, light emission from the phosphorescence-emitting compound (MC-2) was confirmed.

<Reference Example 37>

A solution was prepared in the same way as in Reference Example 18 except that the phosphorescence-emitting compound (MC-2) shown below was used instead of the phosphorescence-emitting compound (MC-1) in Reference Example 18. The solution was irradiated with UV rays with wavelength of 254 nm. As a result, light emission from the phosphorescence-emitting compound (MC-2) was confirmed.

<Reference Example 38>

A solution was prepared in the same way as in Reference Example 19 except that the phosphorescence-emitting compound (MC-2) shown below was used instead of the phosphorescence-emitting compound (MC-1) in Reference Example 19. The solution was irradiated with UV rays with wavelength of 254 nm. As a result, light emission from the phosphorescence-emitting compound (MC-2) was confirmed.

<Example 39>

A solution was prepared in the same way as in Example 22 except that the phosphorescence-emitting compound (MC-2) shown below was used instead of the phosphorescence-emitting compound (MC-1) in Example 22. The solution was irradiated with UV rays with wavelength of 365 nm. As a result, light emission from the phosphorescence-emitting compound (MC-2) was confirmed.

<Example 40>

A solution was prepared in the same way as in Example 23 except that the phosphorescence-emitting compound

(MC-2) shown below was used instead of the phosphorescence-emitting compound (MC-1) in Example 23. The solution was irradiated with UV rays with wavelength of 365 nm. As a result, light emission from the phosphorescence-emitting compound (MC-2) was confirmed.

<Example 41>

A solution was prepared in the same way as in Example 26 except that the phosphorescence-emitting compound (MC-2) shown below was used instead of the phosphorescence-emitting compound (MC-1) in Example 26. The solution was irradiated with UV rays with wavelength of 365 nm. As a result, light emission from the phosphorescence-emitting compound (MC-2) was confirmed.

<Example 42>

A solution was prepared in the same way as in Example 28 except that the phosphorescence-emitting compound (MC-2) shown below was used instead of the phosphorescence-emitting compound (MC-1) in Example 28. The solution was irradiated with UV rays at 365 nm. As a result, light emission from the phosphorescence-emitting compound (MC-2) was confirmed.

<Example 43>

A solution was prepared in the same way as in Example 32 except that the phosphorescence-emitting compound (MC-2) shown below was used instead of the phosphorescence-emitting compound (MC-1) in Example 32. The solution was irradiated with UV rays at 254 nm. As a result, light emission from the phosphorescence-emitting compound (MC-2) was confirmed.

<Comparative Example 2>

A film of a suspension of poly(3,4)ethylenedioxythiophene)/polystyrene sulfonic acid (manufactured by Bayer AG, trade name: Baytron P AI4083) was formed as a hole injection layer at a thickness of 65 nm by spin coating on a glass substrate coated with an ITO film at a thickness of 150 nm by a sputtering method. The film was dried at 200°C for 10 minutes on a hot plate. Next, the compound (P-4) was dissolved at a concentration of 1.0 wt% in xylene. Moreover, the phosphorescence-emitting compound (MC-1) was also dissolved as a phosphorescence-emitting material at a concentration of 1.0 wt% in xylene. Furthermore, the compound (P-4) thus obtained and the phosphorescence-emitting compound (MC-1) were mixed at a weight ratio of 70/30 to prepare a solution. This mixed solution was applied onto the hole injection layer by spin coating at 800 rpm. This light-emitting layer had a film thickness of 70 nm. Then, the film was dried at 90°C for 10 minutes in a nitrogen atmosphere containing 10 ppm or lower moisture and oxygen concentrations. Then, barium (approximately 5 nm) and subsequently aluminum (approximately 100 nm) were deposited as a cathode to prepare an organic EL device. The device comprises ITO/Baytron P (65 nm)/(compound (P-4)/phosphorescence-emitting compound (MC-1)=70/30 (70 nm))/Ba/Al. In this context, the metal deposition was started after the degree of vacuum reached $1 \times 10^{-4}$ Pa or lower.
A voltage was applied to the obtained device. As a result, peak wavelengths of 440 nm derived from (P-4) and 520 nm derived from (MC-1) were observed simultaneously. This device had the largest luminous efficiency of 0.34 cd/A. The compound (P-4) was synthesized according to a method described in US6512083.

<Comparative Example 3>

A film of a suspension of poly(3,4)ethylenedioxythiophene/polystyrene sulfonic acid (manufactured by Bayer AG, trade name: Baytron P AI4083) was formed as a hole injection layer at a thickness of 65 nm by spin coating on a glass substrate coated with an ITO film at a thickness of 150 nm by a sputtering method. The film was dried at 200°C for 10 minutes on a hot plate. Next, the polymer (P-4) was dissolved at a concentration of 3.5 wt% in xylene. The phosphorescence-emitting compound (MC-1) was also dissolved as a phosphorescence-emitting material at a concentration of 3.5 wt% in xylene. Moreover, the polymer represented by the formula (PP-1) was also dissolved at a concentration of 3.5 wt% in xylene. Furthermore, the polymer (P-4), the phosphorescence-emitting compound (MC-1) and the polymer (PP-1) were mixed at a weight ratio of 20/30/50 to prepare a solution. This mixed solution was applied onto the hole injection layer by spin coating at 2500 rpm. This light-emitting layer had a film thickness of approximately 85 nm. Then, the film was dried at 90°C for 10 minutes in a nitrogen atmosphere containing 10 ppm or lower moisture and oxygen concentrations. Then, barium (approximately 5 nm) and subsequently aluminum (approximately 100 nm) were deposited as a cathode to prepare an EL device. The device comprises ITO/Baytron P (65 nm)/(polymer (P-4)/phosphorescence-emitting compound (MC-1)/polymer (PP-1)=20/30/50 (85 nm))/Ba/Al. In this context, the metal deposition was started after the degree of vacuum reached $1\times10^{-4}$ Pa or lower.
A voltage was applied to the obtained device. As a result, this device had the largest luminous efficiency of 2.0 cd/A.

<Comparative Example 4>

A 10 µl aliquot of the mixed solution comprising the polymer (P-4) and the phosphorescence-emitting compound (MC-1) was added dropwise to a slide glass and dried in air to obtain a solid film. This film was irradiated with UV rays at 365 nm. As a result, light emission was darker than that from only the polymer (P-4), and difference in color was hardly observed.

INDUSTRIAL APPLICABILITY

A composition and a polymer of the present invention give light-emitting devices excellent in luminous efficiency, when used in the preparation of light-emitting devices or the like.

**Claims**

1. A composition comprising a compound having a pyrimidine ring structure and a phosphorescence-emitting compound, wherein the compound having a pyrimidine ring structure has a pyrimidine ring structure represented by the general formula (1), (2), (3), (1a) (2a) or (3a) and a partial structure adjacent to the pyrimidine ring structure, the partial structure having at least two n-conjugated electrons, wherein the pyrimidine ring structure and the partial structure form a dihedral angle of 30° or larger therebetween calculated from the optimized structure of the ground state by a Hartree-Fock method, 6-31g* being used as a basis function, or when 6-31g* is unavailable, LANL2DZ being used instead:

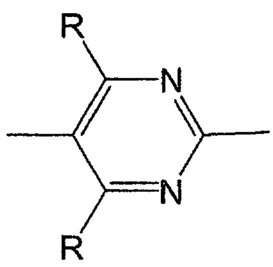

(1)

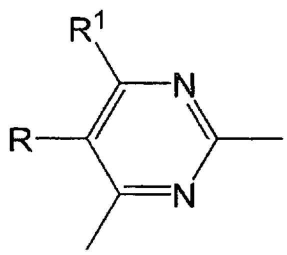

(2)

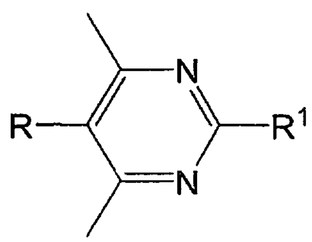

(3)

wherein R and $R^1$ each independently represent a hydrogen atom or a monovalent substituent, and when a plurality of R and $R^1$ are present, they may be the same or different;

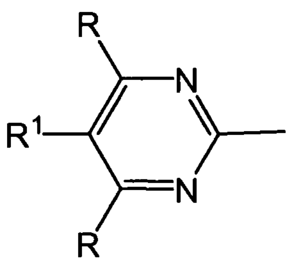

(1a)

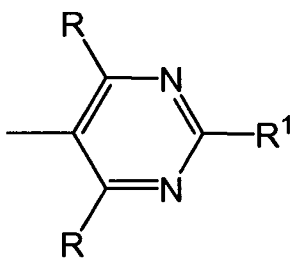

(2a)

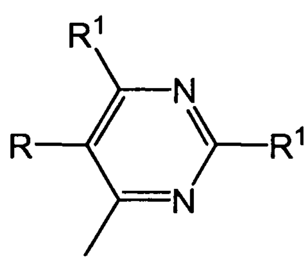

(3a)

wherein R and $R^1$ are as defined above, and when a plurality of R and $R^1$ are present, they may be the same or different;
the partial structure being selected from divalent and trivalent aromatic groups, and structures represented by the following formula (4):

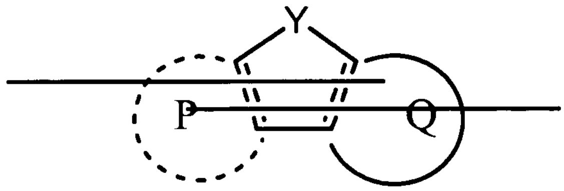

(4)

wherein

- the P ring may be absent;
- the P ring, if present, and the Q ring each independently represent an aromatic ring;
- if the P ring is present, each of the two bonds (——) are present on the P ring or the Q ring; and
- if the P ring is absent, each of the two bonds (——) are present on the Y-containing five-membered or six-membered ring or the Q ring;

and wherein the P ring, the Q ring or the Y-containing five-membered or six-membered ring may have a substituent selected from the group consisting of an alkyl group, an alkoxy group, an alkylthio group, an aryl group, an aryloxy group, an arylthio group, an arylalkyl group, an arylalkoxy group, an arylalkylthio group, an arylalkenyl group, an arylalkynyl group, an amino group, a substituted amino group, a silyl group, a substituted silyl group, a halogen atom, an acyl group, an acyloxy group, an imine residue, an amide group, an acid imide group, a monovalent heterocyclic group, a carboxyl group, a substituted carboxyl group and a cyano group; Y represents -O-, -S-, -Se-, -B($R^0$)-, -Si($R^2$) ($R^3$)-, - P($R^4$)-, -P($R^5$) (=O)-, -C($R^6$) ($R^7$) -, -N($R^8$) -, - C($R^9$) ($R^{10}$) -C($R^{11}$) ($R^{12}$) -, -O-C($R^{13}$) ($R^{14}$) -, -S-C($R^{15}$) ($R^{16}$) -, -N-C($R^{17}$) ($R^{18}$) -, -Si ($R^{19}$) ($R^{20}$)-C($R^{21}$) ($R^{22}$)-, -Si ($R^{23}$) ($R^{24}$) -Si ($R^{25}$) ($R^{26}$) -,-C($R^{27}$) =C ($R^{28}$) -, -N=C($R^{29}$) -, or -Si($R^{30}$)=C($R^{31}$)-; $R^0$ and $R^2$ to $R^{31}$ each independently represent a hydrogen atom, an alkyl group, an alkoxy group, an alkylthio group, an aryl group, an aryloxy group, an arylthio group, an arylalkyl group, an arylalkoxy group, an arylalkylthio group, an arylalkenyl group, an arylalkynyl group, an amino group, a substituted amino group, a silyl group, a substituted silyl group, a silyloxy group, a substituted silyloxy group, a monovalent heterocyclic group or a halogen atom;

or the partial structure is an aromatic amine having a structure represented by the following formula:

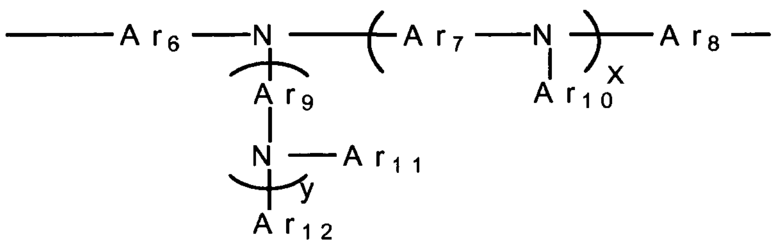

wherein $Ar_6$, $Ar_7$, $Ar_8$ and $Ar_9$ each independently represent an arylene group or a divalent heterocyclic group; $Ar_{10}$, $Ar_{11}$ and $Ar_{12}$ each independently represent an aryl group or a monovalent heterocyclic group; $Ar_6$ to $Ar_{12}$ may have a substituent; and x and y each independently represent 0 or 1, wherein $0 \leq x+y \leq 1$.

2. The composition according to claim 1, wherein the compound having a pyrimidine ring structure has the lowest triplet excitation energy of 2.7 eV or larger calculated by a computational chemical approach, wherein the quantum chemical calculation program Gaussian 03 is used as the computational chemical approach, the structure of the ground state being optimized by a Hartree-Fock method, the values of the $T_1$ lowest triplet excitation energy and the LUMO energy level being calculated in the optimized structure using a time-dependent density functional method at a B3P86 level, 6-31g* being used as a basis function, or when 6-31g* is unavailable, LANL2DZ being used instead.

**3.** The composition according to claim 1 or 2, wherein the compound having a pyrimidine ring structure has an absolute value of the lowest unoccupied molecular orbital energy level of 1.5 eV or larger calculated by the computational chemical approach defined in claim 2.

**4.** The composition according to any one of claims 1 to 3, wherein at least one of the R and the $R^1$ is an alkyl group, an alkoxy group, an aryl group which may have a substituent or a heteroaryl group which may have a substituent; or at least one of the plurality of R and the plurality of $R_1$ is an alkyl group having 3 to 10 carbon atoms or an alkoxy group having 3 to 10 carbon atoms.

**5.** The composition according to any one of claims 1 to 4, wherein at least one of the R is a monovalent substituent having a total of three or more atoms exclusive of hydrogen atoms.

**6.** The composition according to any one of claims 1 to 5, wherein the lowest triplet excitation energy (ETP) of the compound having a pyrimidine ring structure satisfies, with a lowest triplet excitation energy (ETT) of the phosphorescence-emitting compound, the following formula:

$$ETT > ETP - 0.5\ (eV).$$

**7.** The composition according to any one of claims 1 to 6, wherein the compound having a pyrimidine ring structure is a polymer.

**8.** The composition according to claim 7, wherein the compound having a pyrimidine ring structure has a structure represented by the following general formula (B):

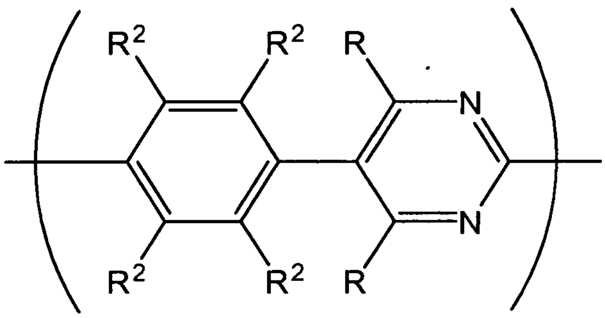

(B)

wherein R is as defined above; $R^2$ represents a hydrogen atom or a monovalent substituent; and when a plurality of R or $R^2$ are present, they may be the same or different.

**9.** A light-emitting thin film or organic semiconductor thin film using a composition according to any one of claims 1 to 8.

**10.** A light-emitting device using a composition according to any one of claims 1 to 8.

**11.** A device which is a planar light source, a segment display device, a dot matrix display device, or an illumination comprising a light-emitting device according to claim 10; or a liquid-crystal display device comprising a light-emitting device according to claim 10 as a backlight.

**Patentansprüche**

**1.** Eine Zusammensetzung, welche eine Verbindung mit einer Pyrimidinringstruktur und eine Phosphoreszenz emittierende Verbindung umfasst, wobei die Verbindung mit einer Pyrimidinringstruktur eine Pyrimidinringstruktur, dargestellt durch die allgemeine Formel (1), (2), (3), (1a), (2a) oder (3a), und eine Teilstruktur angrenzend an die Pyrimidinringstruktur aufweist, wobei die Teilstruktur mindestens zwei $\pi$-konjugiert Elektronen aufweist, wobei die Pyrimidinringstruktur und die Teilstruktur einen Torsionswinkel zwischen sich von 30° oder mehr bilden, berechnet aus der optimierten Struktur des Grundzustands durch eine Hartree-Fock-Methode, wobei 6-31g* als Basisfunktion verwendet wird oder, wenn 6-31g* nicht verfügbar ist, stattdessen LANL2DZ verwendet wird:

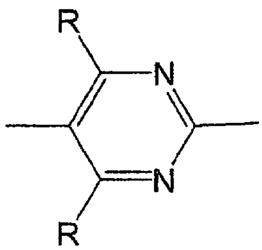
(1)

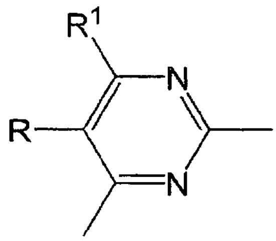
(2)

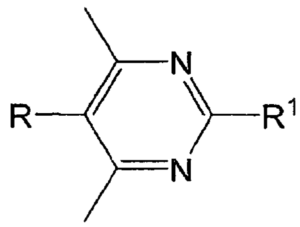
(3)

wobei R und $R^1$ jeweils unabhängig ein Wasserstoffatom oder einen einwertigen Substituenten darstellen und, wenn mehrere Reste R und $R^1$ vorhanden sind, diese gleich oder verschieden sein können;

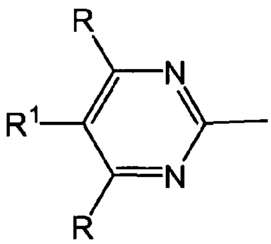
(1a)

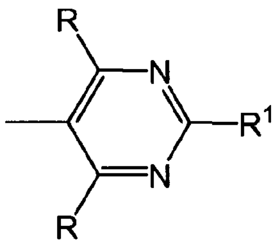
(2a)

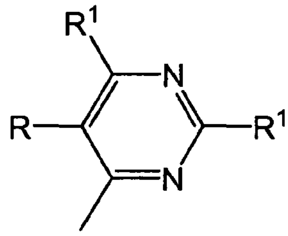
(3a)

wobei R und $R^1$ wie vorstehend definiert sind und, wenn mehrere Reste R und $R^1$ vorhanden sind, diese gleich oder verschieden sein können;
wobei die Teilstruktur ausgewählt ist aus zweiwertigen und dreiwertigen aromatischen Resten und Strukturen, die durch die folgende Formel (4) dargestellt sind:

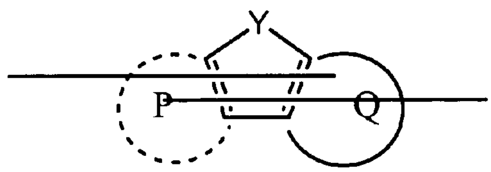
(4)

wobei

- der P-Ring nicht vorhanden sein kann;
- der P-Ring, falls vorhanden, und der Q-Ring jeweils unabhängig einen aromatischen Ring darstellen;
- falls der P-Ring vorhanden ist, jede der zwei Bindungen (-) am P-Ring oder am Q-Ring vorhanden sind; und
- falls der P-Ring nicht vorhanden ist, jede der zwei Bindungen (-) am Y-enthaltenden fünf-gliedrigen oder sechsgliedrigen Ring oder am Q-Ring vorhanden sind;

und wobei der P-Ring, der Q-Ring oder der Y-enthaltende fünf-gliedrige oder sechsgliedrige Ring einen Substituenten

aufweisen kann, der ausgewählt ist aus der Gruppe bestehend aus einem Alkylrest, einem Alkoxyrest, einem Alkylthiorest, einem Arylrest, einem Aryloxyrest, einem Arylthiorest, einem Arylalkylrest, einem Arylalkoxyrest, einem Arylalkylthiorest, einem Arylalkenylrest, einem Arylalkinylrest, einem Aminorest, einem substituierten Aminorest, einem Silylrest, einem substituierten Silylrest, einem Halogenatom, einem Acylrest, einem Acyloxyrest, einem Iminrest, einem Amidrest, einem Säureimidrest, einem einwertigen heterocyclischen Rest, einem Carboxylrest, einem substituierten Carboxylrest und einer Cyanogruppe; Y gleich -O-, -S-, -Se-,- $B(R^0)$-, $-Si(R^2)(R^3)$-, $-P(R^4)$-, $-P(R^S)(=O)$-, $-C(R^6)(R^7)$-, $-N(R^8)$-, $-C(R^9)(R^{10})-C(R^{11})(R^{12})$-, $-O-C(R^{13})(R^{14})$-, $-S-C(R^{15})(R^{16})$-, $-N-C(R^{17})(R^{18})$-, $-Si(R^{19})(R^{20})-C(R^{21})(R^{22})$-, $-Si(R^{23})(R^{24})-Si(R^{25})(R^{26})$-, $-C(R^{27})=C(R^{28})$-, $-N=C(R^{29})$- oder $-Si(R^{30})=C(R^{31})$- darstellt; $R^0$ und $R^2$ bis $R^{31}$ jeweils unabhängig ein Wasserstoffatom, einen Alkylrest, einen Alkoxyrest, einen Alkylthiorest, einen Arylrest, einen Aryloxyrest, einen Arylthiorest, einen Arylalkylrest, einen Arylalkoxyrest, einen Arylalkylthiorest, einen Arylalkenylrest, einen Arylalkinylrest, einen Aminorest, einen substituierten Aminorest, einen Silylrest, einen substituierten Silylrest, einen Silyloxyrest, einen substituierten Silyloxyrest, einen einwertigen heterocyclischen Rest oder ein Halogenatom darstellen;

oder die Teilstruktur ein aromatisches Amin mit einer Struktur, die durch die folgende Formel dargestellt ist, ist:

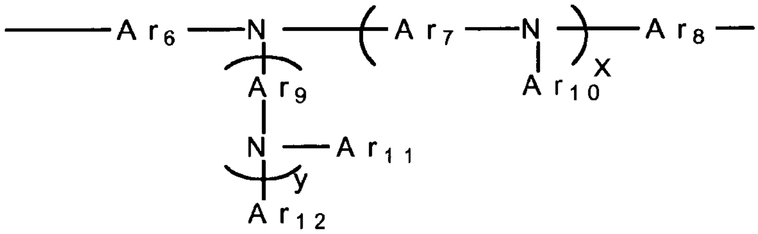

wobei $Ar_6$, $Ar_7$, $Ar_8$ und $Ar_9$ jeweils unabhängig einen Arylenrest oder einen zweiwertigen heterocyclischen Rest darstellen; $Ar_{10}$, $Ar_{11}$ und $Ar_{12}$ jeweils unabhängig einen Arylrest oder einen einwertigen heterocyclischen Rest darstellen; $Ar_6$ bis $Ar_{12}$ einen Substituenten aufweisen können; und x und y jeweils unabhängig 0 oder 1 darstellen, wobei $0 \leq x+y \leq 1$ gilt.

**2.** Die Zusammensetzung gemäß Anspruch 1, wobei die Verbindung mit einer Pyrimidinringstruktur die niedrigste Triplett-Anregungsenergie von 2,7 eV oder mehr aufweist, berechnet durch eine chemische Rechenmethode, wobei als die chemische Rechenmethode das quantenchemische Berechnungsprogramm Gaussian 03 verwendet wird, die Struktur des Grundzustands mit einer Hartree-Fock-Methode optimiert wird, die Werte der niedrigsten Triplett-Anregungsenergie $T_1$ und des LUMO Energieniveaus in der optimierten Struktur unter Verwendung eines zeitabhängigen Dichtefunktionalverfahrens auf einem B3P86 Niveau berechnet werden, wobei 6-31g* als Basisfunktion verwendet wird oder, wenn 6-31g* nicht verfügbar ist, stattdessen LANL2DZ verwendet wird.

**3.** Die Zusammensetzung gemäß Anspruch 1 oder 2, wobei die Verbindung mit einer Pyrimidinringstruktur einen absoluten Wert des Energieniveaus des niedrigsten unbesetzten Molekülorbitals von 1,5 eV oder mehr, berechnet durch die chemische Rechenmethode wie in Anspruch 2 definiert, aufweist.

**4.** Die Zusammensetzung gemäß einem der Ansprüche 1 bis 3, wobei mindestens einer der Reste R und $R^1$ ein Alkylrest, ein Alkoxyrest, ein Arylrest, welcher einen Substituenten aufweisen kann, oder ein Heteroarylrest, welcher einen Substituenten aufweisen kann, ist; oder mindestens einer der Mehrzahl der Reste R und der Mehrzahl der Reste $R^1$ ein Alkylrest mit 3 bis 10 Kohlenstoffatomen oder ein Alkoxyrest mit 3 bis 10 Kohlenstoffatomen ist.

**5.** Die Zusammensetzung gemäß einem der Ansprüche 1 bis 4, wobei mindestens einer der Reste R ein einwertiger Substituent, welcher eine Gesamtanzahl von drei oder mehr Atomen ausschließlich Wasserstoffatomen aufweist, ist.

**6.** Die Zusammensetzung gemäß einem der Ansprüche 1 bis 5, wobei die niedrigste Triplett-Anregungsenergie (ETP) der Verbindung mit einer Pyrimidinringstruktur mit einer niedrigsten Triplett-Anregungsenergie (ETT) der Phosphoreszenz emittierenden Verbindung die folgende Formel erfüllt:

$$ETT > ETP - 0,5 \text{ (eV)}.$$

**7.** Die Zusammensetzung gemäß einem der Ansprüche 1 bis 6, wobei die Verbindung mit einer Pyrimidinringstruktur ein Polymer ist.

**8.** Die Zusammensetzung gemäß Anspruch 7, wobei die Verbindung mit einer Pyrimidinringstruktur eine Struktur, die durch die folgende allgemeine Formel (B) dargestellt ist, aufweist:

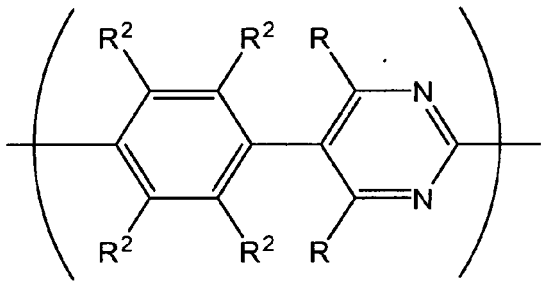

(B)

wobei R wie vorstehend definiert ist; $R^2$ ein Wasserstoffatom oder einen einwertigen Substituenten darstellt; und wenn mehrere Reste R oder $R^2$ vorhanden sind, diese gleich oder verschieden sein können.

**9.** Ein Licht emittierender Dünnfilm oder organischer Halbleiter-Dünnfilm, der eine Zusammensetzung gemäß einem der Ansprüche 1 bis 8 verwendet.

**10.** Eine Licht emittierende Vorrichtung, die eine Zusammensetzung gemäß einem der Ansprüche 1 bis 8 verwendet.

**11.** Eine Vorrichtung, die eine flächige Lichtquelle, eine Segmentanzeigevorrichtung, eine Punktmatrixanzeigevorrichtung oder eine Beleuchtung ist, umfassend eine Licht emittierende Vorrichtung gemäß Anspruch 10; oder eine Flüssigkristallanzeigevorrichtung, die eine Licht emittierende Vorrichtung gemäß Anspruch 10 als Hintergrundbeleuchtung umfasst.

## Revendications

**1.** Composition comprenant un composé ayant une structure cyclique de pyrimidine et un composé émettant une phosphorescence, où le composé ayant une structure cyclique de pyrimidine a une structure cyclique de pyrimidine représentée par la formule générale (1), (2), (3), (1a), (2a) ou (3a) et une structure partielle adjacente à la structure cyclique de pyrimidine, la structure partielle ayant au moins deux électrons conjugués $\pi$, où la structure cyclique de pyrimidine et la structure partielle forment un angle dièdre de 30° ou plus entre elles calculé d'après la structure optimisée de l'état fondamental par un procédé de Hartree-Fock, 6-31g* étant utilisé comme fonction de base, ou quand 6-31g* n'est pas disponible, LANL2DZ étant utilisé à la place :

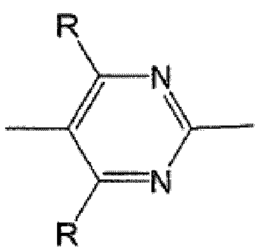

(1)

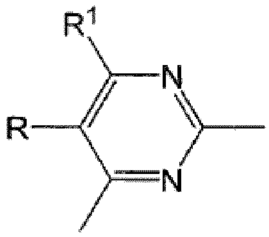

(2)

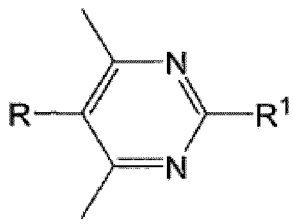

(3)

où R et $R^1$ représentent chacun indépendamment un atome d'hydrogène ou un substituant monovalent, et quand

une pluralité de R et $R^1$ sont présents, ils peuvent être identiques ou différents ;

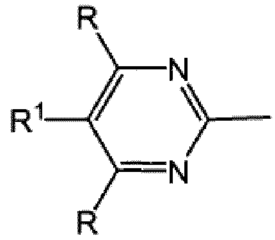
(1a)

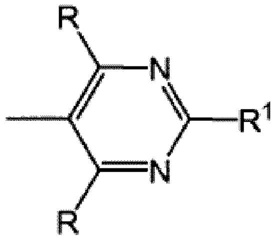
(2a)

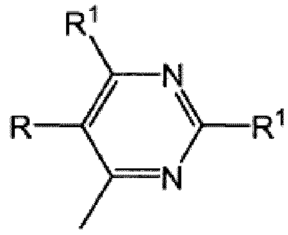
(3a)

où R et $R^1$ sont définis comme ci-dessus, et quand une pluralité de R et $R^1$ sont présents, ils peuvent être identiques ou différents ;
la structure partielle étant choisie parmi les groupes aromatiques divalents et trivalents, et les structures représentées par la formule (4) suivante :

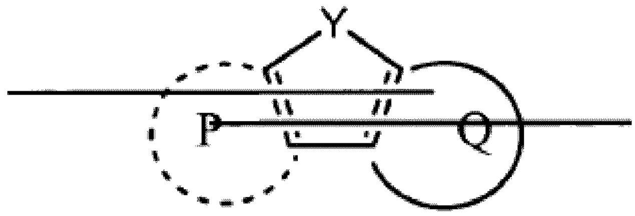
(4)

où

- le cycle P peut être absent ;
- le cycle P, s'il est présent, et le cycle Q représentent chacun indépendamment un cycle aromatique ;
- si le cycle P est présent, chacune des deux liaisons (—) est présente sur le cycle P ou le cycle Q ; et
- si le cycle P est absent, chacune des deux liaisons (—) est présente sur le cycle à cinq chaînons ou à six chaînons contenant Y ou le cycle Q ;

et où le cycle P, le cycle Q et le cycle à cinq chaînons ou à six chaînons contenant Y peut avoir un substituant choisi dans le groupe consistant en un groupe alkyle, un groupe alcoxy, un groupe alkylthio, un groupe aryle, un groupe aryloxy, un groupe arylthio, un groupe arylalkyle, un groupe arylalcoxy, un groupe arylalkylthio, un groupe arylalcényle, un groupe arylalcynyle, un groupe amino, un groupe amino substitué, un groupe silyle, un groupe silyle substitué, un atome d'halogène, un groupe acyle, un groupe acyloxy, un résidu imine, un groupe amide, un groupe imide d'acide, un groupe hétérocyclique monovalent, un groupe carboxyle, un groupe carboxyle substitué et un groupe cyano ; Y représente -O-, -S-, -Se-, -B($R^0$)-, -Si($R^2$) ($R^3$)-, -P($R^4$)-, -P($R^5$) (=O)-, -C($R^6$) ($R^7$)-, -N($R^8$)-, -C($R^9$) ($R^{10}$)-($C^{11}$) ($R^{12}$)-, -O-C($R^{13}$) ($R^{14}$)-, -S-CC($R^{15}$) ($R^{16}$)-, -N-C($R^{17}$) ($R^{18}$)-, -Si($R^{19}$) ($R^{20}$)-C($R^{21}$) ($R^{22}$)-, -Si($R^{23}$) ($R^{24}$)-Si($R^{25}$) ($R^{26}$)-, -C($R^{27}$)=C($R^{28}$)-, -N=C($R^{29}$)-, ou -Si($R^{30}$)=C($R^{31}$)- ; $R^0$ et $R^2$ à $R^{31}$ représentent chacun indépendamment un atome d'hydrogène, un groupe alkyle, un groupe alcoxy, un groupe alkylthio, un groupe aryle, un groupe aryloxy, un groupe arylthio, un groupe arylalkyle, un groupe arylalcoxy, un groupe arylalkylthio, un groupe arylalcényle, un groupe arylalcynyle, un groupe amino, un groupe amino substitué, un groupe silyle, un groupe silyle substitué, un groupe silyloxy, un groupe silyloxy substitué, un groupe hétérocyclique monovalent ou un atome d'halogène ;

ou bien la structure partielle est une amine aromatique ayant une structure représentée par la formule suivante :

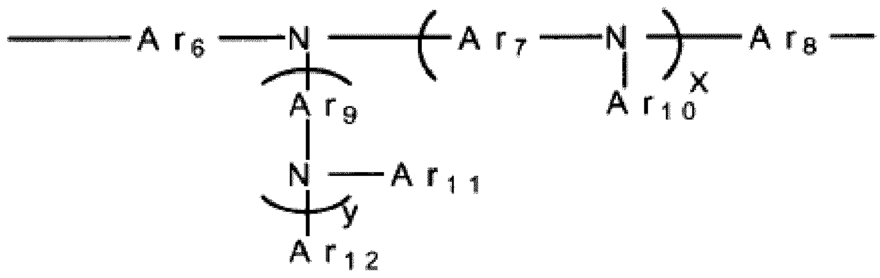

où $Ar_6$, $Ar_7$, $Ar_8$ et $Ar_9$ représentent chacun indépendamment un groupe arylène ou un groupe hétérocyclique divalent ; $Ar_{10}$, $Ar_{11}$ et $Ar_{12}$ représentent chacun indépendamment un groupe aryle ou un groupe hétérocyclique monovalent ; $Ar_6$ à $Ar_{12}$ peuvent avoir un substituant ; et x et y représentent chacun indépendamment 0 ou 1, où $0 \leq x+y \leq 1$.

2. Composition selon la revendication 1, où le composé ayant une structure cyclique de pyrimidine a la plus basse énergie d'excitation de triplet de 2,7 eV ou plus calculée par une approche chimique informatisée, où le programme de calcul de chimie quantique Gaussian 03 est utilisé comme approche chimique informatisée, la structure de l'état fondamental étant optimisée par un procédé de Hartree-Fock, les valeurs de la plus basse énergie d'excitation de triplet $T_1$ et le niveau d'énergie LUMO étant calculés dans la structure optimisée en utilisant un procédé de fonction de densité dépendant du temps à un niveau B3P86, 6-31g* étant utilisé comme fonction de base, ou quand 6-31g* n'est pas disponible, LANL2DZ étant utilisé à la place.

3. Composition selon la revendication 1 ou 2, où le composé ayant une structure cyclique de pyrimidine a une valeur absolue du plus bas niveau d'énergie d'orbitale moléculaire inoccupé de 1,5 eV ou plus calculée par l'approche chimique informatisée définie dans la revendication 2.

4. Composition selon l'une quelconque des revendications 1 à 3, où au moins l'un des R et des $R^1$ est un groupe alkyle, un groupe alcoxy, un groupe aryle qui peut avoir un substituant ou un groupe hétéroaryle qui peut avoir un substituant ; ou bien au moins l'un de la pluralité de R et de la pluralité de $R_1$ est un groupe alkyle ayant 3 à 10 atomes de carbone ou un groupe alcoxy ayant 3 à 10 atomes de carbone.

5. Composition selon l'une quelconque des revendications 1 à 4, où au moins l'un des R est un substituant monovalent ayant un total de trois atomes ou plus à l'exclusion des atomes d'hydrogène.

6. Composition selon l'une quelconque des revendications 1 à 5, où la plus basse énergie d'excitation de triplet (ETP) du composé ayant une structure cyclique de pyrimidine satisfait, avec une plus basse énergie d'excitation de triplet (ETT) du composé émettant une phosphorescence, la formule suivante :

$$ETT > ETP - 0,5\ (eV).$$

7. Composition selon l'une quelconque des revendications 1 à 6, où le composé ayant une structure cyclique de pyrimidine est un polymère.

8. Composition selon la revendication 7, où le composé ayant une structure cyclique de pyrimidine a une structure représentée par la formule générale (B) suivante :

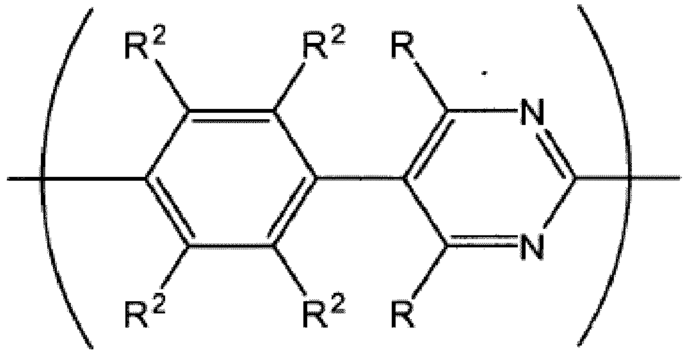

(B)

où R est défini comme ci-dessus ; $R^2$ représente un atome d'hydrogène ou un substituant monovalent ; et quand une pluralité de R ou $R^2$ sont présents, ils peuvent être identiques ou différents.

**9.** Couche mince émettant de la lumière ou couche mince de semi-conducteur organique utilisant une composition selon l'une quelconque des revendications 1 à 8.

**10.** Dispositif émettant de la lumière utilisant une composition selon l'une quelconque des revendications 1 à 8.

**11.** Dispositif qui est une source lumineuse plane, un dispositif d'affichage à segments, un dispositif d'affichage à matrice de points ou un éclairage comprenant un dispositif émettant de la lumière selon la revendication 10 ; ou un dispositif d'affichage à cristaux liquides comprenant un dispositif émettant de la lumière selon la revendication 10 comme éclairage de fond.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2002050483 A
- JP 2002241455 A
- US 2006180806 A
- US 2006093852 A
- JP 2002105444 A
- JP 2005116238 A
- WO 2002066552 A
- WO 2004020504 A
- WO 2004020448 A
- JP 63070257 A
- JP 63175860 A
- JP 2135359 A
- JP 2135361 A
- JP 2209988 A
- JP 3037992 A
- JP 3152184 A
- JP 2005126686 A
- JP 2004292432 A
- WO 02066552 A
- US 6512083 B


### Non-patent literature cited in the description


- *APPLIED PHYSICS LETTERS,* 2002, vol. 80 (13), 2308
- *Nature,* 1998, vol. 395, 151
- *Appl. Phys, Lett.,* 1999, vol. 75 (1), 4
- *Proc. SPIE-Int. Soc. Opt. Eng.,* 2001, vol. 4105
- *Organic Light-Emitting Materials and Devices IV,* vol. 119
- *J. Am. Chem. Soc.,* 2001, vol. 123, 4304
- *Appl. Phys. Lett.,* 1997, vol. 71 (18), 2596
- *Syn. Met.,* 1998, vol. 94 (1), 103
- *Syn. Met.,* 1999, vol. 99 (2), 1361
- *Adv. Mater.,* 1999, vol. 11 (10), 852
- *Inorg. Chem.,* 2003, vol. 42, 8609
- *Inorg. Chem.,* 2004, vol. 43, 6513
- *Journal of the SID,* 2003, vol. 11-1, 161